(19) Europäisches Patentamt
European Patent Office
Office européen des brevets

(11) EP 4 276 921 A1

(12) EUROPEAN PATENT APPLICATION

(43) Date of publication:
15.11.2023  Bulletin 2023/46

(51) International Patent Classification (IPC):
H01L 33/00 (2010.01)  H01L 33/30 (2010.01)

(21) Application number: 23172642.3

(22) Date of filing: 10.05.2023

(52) Cooperative Patent Classification (CPC):
H01L 33/007; H01L 33/0075; H01L 33/30;
H01L 33/305

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 12.05.2022  US 202263341024 P
01.05.2023  US 202318309994

(71) Applicant: The Regents of the University of
California
Oakland CA 94607-5200 (US)

(72) Inventors:
• WANG, Michael
Santa Clara, 95051 (US)
• ZOLLNER, Christian J.
Goleta, 93117 (US)
• YAO, Yifan
Goleta, 93117 (US)
• IZA, Michael
Goleta, 93117 (US)
• NAKAMURA, Shuji
Santa Barbara, 93160 (US)

(74) Representative: Murgitroyd & Company
Murgitroyd House
165-169 Scotland Street
Glasgow G5 8PL (GB)

(54) HIGH EFFICIENCY ULTRAVIOLET LIGHT-EMITTING DEVICES INCORPORATING A NOVEL MULTILAYER STRUCTURE

(57) A multilayer structure comprising regions of higher aluminum (Al) composition as compared to adjacent layers, in combination with an undulating active region and controlled buffer layer crystal quality, promotes radiative recombination and improves the performance and efficiency of ultraviolet (UV) or far-UV light-emitting diodes (LEDs), laser diode (LDs), or other light emitting devices.

FIG. 1D  FIG. 1C  FIG. 1B  FIG. 1A

EP 4 276 921 A1

**Description**

CROSS REFERENCE TO RELATED APPLICATIONS

This application claims priority to the following co-pending and commonly-assigned U.S. applications:

> U.S. Utility Application Serial No. 18/309,994, filed on May 1, 2023, by Michael Wang, Christian Zollner, Yifan Yao, Michael Iza, and Shuji Nakamura, entitled "HIGH EFFICIENCY ULTRAVIOLET LIGHT-EMITTING DEVICES INCORPORATING A NOVEL MULTILAYER STRUCTURE," attorneys' docket number G&C 30794.0819USU1 (UC-2022-794-2);
> which application claims the benefit under 35 U.S.C. Section 119(e) of the following co-pending and commonly-assigned application:

> > U.S. Provisional Application Serial No. 63/341,024, filed on May 12, 2022, by Michael Wang, Christian Zollner, Yifan Yao, Michael Iza, and Shuji Nakamura, entitled "HIGH EFFICIENCY ULTRAVIOLET LIGHT-EMITTING DEVICES INCORPORATING A NOVEL MULTILAYER STRUCTURE," attorneys' docket number G&C 30794.0819USP1 (UC-2022-794-1);
> > both of which applications are incorporated by reference herein.

BACKGROUND OF THE INVENTION

1. Field of the Invention.

This invention relates to a novel design for ultraviolet (UV) or far-UV light-emitting diodes (LEDs) that are partially or fully transparent. In these devices, the semiconductor layer structures include novel doped multilayer structures which improve the performance of the devices. Therefore, these devices are superior to the prior art which does not make use of these particular doped multilayer structures.

There is a strong desire for efficient UV LED devices. Wavelengths below 300 nanometers (nm) are universally germicidal so that UV disinfection is considered one of the most promising means to fight pandemic disease outbreaks, improve hygiene of water supplies and medical settings, and improve protocols for disinfection of air and surfaces. Other applications of ultraviolet light include short-range optical communication, three-dimensional (3D) printing, curing, therapeutic uses, and many others.

The current state of the art in UV LEDs remains about a factor of five less energy-efficient, and a factor of 100 more expensive (in per Watt terms) than Mercury (Hg) vapor lamp sources. On the other hand, solid-state semiconductor LED based UV light sources are expected to provide many benefits including miniaturization, rapid on/off and dimming for smart functionality, wavelength tunability, durability, and low power consumption. In the future, it is anticipated that UV LEDs will achieve similar efficiency and cost to their blue and white light emitting LED counterparts (which vastly outperform all other visible light emitting technologies), and the market for UV LEDs will grow rapidly. In order to achieve increased market share and improved global health outcomes, novel technologies for efficient UV LEDs are needed.

2. Description of the Related Art.

The usefulness of gallium nitride (GaN), and its ternary and quaternary compounds incorporating aluminum and indium (AlGaN, InGaN, AlInGaN), has been well established for the fabrication of visible and UV light emitting optoelectronic devices and high-power electronic devices. These III-nitride devices are typically grown epitaxially using molecular beam epitaxy (MBE), metalorganic chemical vapor deposition (MOCVD), hydride vapor phase epitaxy (HVPE), or other methods. The terms "III-nitride" or "nitride" as used herein refer to any alloy composition of $(Al,Ga,In,B,Sc,Y)N$ semiconductors having the formula $Al_jGa_mIn_nB_xSc_yY_zN$ where $0 \leq j \leq 1$, $0 \leq m \leq 1$, $0 \leq n \leq 1$, $0 \leq x \leq 1$, $0 \leq y \leq 1$, $0 \leq z \leq 1$, and $j+m+n+x+y+z=1$.

The development of AlGaN for short wavelength devices enabled III-nitride-based LEDs and laser diodes (LDs) to overtake many other research ventures. Consequently, UV LEDs have begun to overtake conventional Hg vapor lamps as the dominant light source for disinfection in some applications such as portable consumer devices and point-of-use water disinfection. The expected market for UV disinfection products is expected to grow significantly in the coming years, but previous UV LED technologies are not yet efficient or inexpensive enough to compete with Hg-based lamps. Technological advances in UV LED efficiency and output power are direly needed to address worldwide water insecurity, improve health outcomes in developing and developed nations alike, and to address the rapidly growing consumer, enterprise, and public demand for disinfection products. Other novel applications, such as nanolithography, curing, dermatological therapeutics, and many others are also expected to benefit from improved UV LED performance. Finally, far UV-C light (<225 nm) has been shown to not be carcinogenic or cataractogenic while still being strongly absorbed by deoxyribonucleic acid (DNA) and ribonucleic acid (RNA), creating a plethora of novel disinfection applications for AlGaN-based devices.

LEDs typically include at least one n-type region, p-type region, and active region. The active region further comprises light-emitting regions (quantum wells) and confinement structures (quantum barriers, spacers, carrier blocking layers, and other structures). Each of these semiconductor layers is in principle capable of emitting light, but highly efficient LED operation results when the vast majority of the light is emitted in the quantum wells, so these will be referred to as the light-emitting regions herein. Light emission from the other structures such as doped layers or confinement structures can in some cases be measurable but is usually considered detrimental to LED efficiency as the recombination in these regions is parasitic on the preferred recombination pathway taking place in the quantum wells.

The external quantum efficiency or total efficiency ($\eta_L$) of LEDs is defined as the total rate of photon emission from the device divided by the rate of injection of electrical carriers into the device, and can be expressed by the following equation:

$$\eta_L = \eta_{rad}\eta_{inj}\eta_{ext}$$

where the light extraction efficiency, $\eta_{ext}$, is defined as the fraction of photons emitted out of the packaged device to those produced within the semiconductor layers, the injection efficiency, $\eta_{inj}$, is defined as the fraction of electron-hole pairs recombining in the active region as opposed to recombining elsewhere in the device, and the radiative efficiency, $\eta_{rad}$ (also known as internal quantum efficiency or IQE), is defined as the fraction of electron-hole pairs recombining in the active region of the device which recombine radiatively, as opposed to non-radiatively.

One way to increase the radiative efficiency of an LED is to reduce the number of non-radiative centers, such as defects and impurities, in the light emitting region. Another way is to improve the localization and confinement of electrons and holes in a quantum well region. This prevents carrier overshoot and loss through nonradiative recombination outside of the quantum well region (increasing injection efficiency) and maximizes the radiative recombination rate inside the light-emitting region (increasing radiative efficiency). For these reasons, high-quality active regions which strongly confine electrical carriers are considered useful for increasing the IQE of UV LEDs.

However, the growth of high efficiency devices using the AlGaN material system remains a challenge. Due to the challenges of material growth of high Al content AlGaN, current AlGaN-based UV emitters suffer from extremely inefficient radiative carrier recombination. The present invention addresses this issue by the use of a device structure which includes a nitride based multilayer structure located adjacent to the active region of the device that enables highly efficient radiative recombination in the active region.

SUMMARY OF THE INVENTION

The objective of this invention is to enhance the light output power of nitride light emitting devices, such as LEDs, and especially UV LEDs, by improving the properties of the active region of a primarily AlGaN-based multiple quantum well structure. Improving the internal quantum efficiency leads to an improvement in the energy efficiency of the nitride light emitting semiconductor, enabling the expansion of nitride semiconductor device applications into various commercial products.

In the prior art, conventional UV LEDs comprise many semiconductor layers deposited epitaxially on or above a substrate. These layers may include at least: n-type material, an active region comprising quantum barriers and wells, an electron blocking layer (EBL), and a p-type material. These layers are typically grown by MOCVD or some other epitaxial method in an n-down configuration, meaning that the n-type layers are deposited first, and the active region and p-type layers are afterwards deposited on or above the n-type layers. This disclosure will assume such an n-down configuration unless otherwise specified, such that terms such as "below" could be understood to mean "to the n-side of', and "above" can be understood to mean "on the p-side of", in some contexts. The present invention introduces an entirely novel feature into the epitaxial layer structure device: doped or undoped multilayer AlGaN structures. These structures drastically improve device output power, efficiency, reliability, lifetime, and uniformity across the growth wafer.

The nitride interlayer "films", "layers", or "structures" discussed in this disclosure may individually or commonly comprise multiple layers having varying or graded compositions, a heterostructure comprising layers of dissimilar (Al,Ga,In,B,Sc,Y)N composition, or one or more layers of dissimilar (Al,Ga,In,B,Sc,Y)N composition. It is to be understood that films referred to as AlGaN films are referred to in such a way for simplicity, with the implicit understanding that the real device may include some In, B, Sc, Y, or any other element without departing from the scope of the present embodiment. For example, a variation of the present invention including multilayer structures with AlGaInN or AlGaBN is understood to be within the scope of this disclosure.

The nitride layers disclosed herein may comprise unintentionally doped or intentionally doped layers, with elements such as iron, magnesium, silicon, oxygen, carbon, and/or zinc, even if not specified directly. The nitride interlayer film may be formed by methods including but not limited to HVPE, MOCVD, or MBE.

The nitride layers may further comprise the nitride interlayers grown in any crystallographic nitride direction, such as on a conventional c-plane oriented nitride semiconductor crystal, or on a nonpolar plane such as a-plane or m-plane, or on any semipolar plane.

The first nitride semiconductor device of the present invention comprises a UV LED incorporating a III-nitride-based multilayer structure containing at least some layers with higher aluminum composition as compared to adjacent layers. This multilayer structure can be located on any part of the device, but is preferably adjacent to the active region of the device, and more preferably located below the active region of the device (i.e., to the n-side of the active region, grown before the active region, or both). It is also noted that the active region is made of a III-nitride semiconductor containing at least some aluminum, preferably made of $Al_xGa_{1-x}N$ alloys where $0 \leq x \leq 1$, having a single or multiple quantum well.

Further, the first nitride semiconductor device of the present invention comprises an n-region below the active region having a plurality of nitride semiconductor films. At least one of the nitride semiconductor layers of the n-region has an n-side multilayer structure, comprising three types of layers with different aluminum molar fractions. Each of the three nitride semiconductor films (denoted a, b, and c) are formed in a repeating pattern, such as (... b/c/b/a...). At least one of these three films has a thickness less than 200 angstroms, with a total multilayer structure thickness of less than 500 nm. The composite structure formed by some number of these repeated alternating layers will henceforth be referred to as the multilayer structure.

Further, in an alternative embodiment of the first nitride semiconductor device, the multilayer structure may comprise a single nitride film type or two different nitride film types repeating in an alternating pattern (a/b/a/b, etc.), containing at least some aluminum, with a total thickness of less than 500 nm. In a more general case of an alternative embodiment, any number of layers (a, b, c, d, e, f... and so on) could be formed, and the layers need not be unique (e.g., layer i may be similar to layer j).

In the first nitride semiconductor device of the present invention, it is preferable that the multilayer structure is made of $Al_xGa_{1-x}N$ ($0 \leq x \leq 1$).

In the preferred embodiment of the first nitride semiconductor device, it is preferable that the multilayer structure is made of alternating layers of a) $Al_xGa_{1-x}N$ ($0 \leq x \leq 1$), b) $Al_yGa_{1-y}N$ ($0 \leq y \leq 1$), and c) $Al_zGa_{1-z}N$ ($0 \leq z \leq 1$). No further restrictions are in general placed on the values of x, y, and z.

Further, in the first nitride semiconductor device of the present invention, the component films within the multilayer structure may differ in thickness.

Further, in the first nitride semiconductor device of the present invention, the n-side multilayer structure may be spaced away from the active region, but preferably is formed in contact with the active region in order to improve the output power characteristics.

Further, in the first nitride semiconductor device of the present invention, the nitride semiconductor films are not doped with an impurity. The term "undoped" represents the status of not being doped intentionally, including where the impurity diffuses from the adjacent nitride semiconductor layers according to the present invention. The impurity concentration due to such diffused impurity often has a gradient concentration in the layers.

Further, in the first nitride semiconductor device of the present invention, the n-type impurity is doped in any of the multilayer structure's component layers thereof. In some cases, doping may be introduced in alternating layers. This is referred to as modulation doping, and the output power of LEDs with modulation doped multilayer structures may be improved. It is to be noted that the n-type impurity can be selected from Group IV and Group VI elements such as Si, Ge, Sn, and S, and preferably Si or Ge is used for the n-type impurity.

Further, in the first nitride semiconductor device of the present invention, the n-type impurity is doped in the multilayer structure. Where the n-type impurity is doped, the concentration is adjusted to be $5 \times 10^{21}/cm^3$ or less, and preferably $1 \times 10^{20}/cm^3$ or less. Where it is more than $5 \times 10^{21}/cm^3$, the nitride semiconductor film has a poor crystal quality so that the output tends to be reduced. This is also adapted for the case where modulation doping is used. Further, it is preferable that the n-type impurity doping is $5 \times 10^{19}/cm^3$ or less to improve epitaxial quality and device performance.

The second nitride semiconductor device of the present invention comprises a combination of the first device as stated in the above description, with the addition of a tunnel junction (TJ) grown atop the p-type nitride film. A TJ may comprise an n-type impurity doped semiconductor layer grown atop the p-type semiconductor layer of the UV LED device. The TJ may further comprise optically transparent elements, increasing the light extraction efficiency of the device. The n-type impurity doped semiconductor may comprise AlGaN, AlN, $Ga_2O_3$, or some other n-type semiconductor material. This nitride layer can be unintentionally doped but is preferably doped with an n-type impurity such as silicon, with doping concentration greater than $5 \times 10^{17}/cm^3$, and more preferably greater than $1 \times 10^{19}/cm^3$. In an alternative embodiment, the TJ may be formed with a wafer-bonded semiconductor rather than a semiconductor grown atop the LED epitaxially.

Further, in the TJ of the second device of the present invention, the TJ films can be composed of multiple layers of various compositions and different impurity doping levels, potentially including undoped layers. In one potential embodiment, the TJ structure contains at least some doped multilayer structure.

Further, the TJ of the second device can be patterned or shaped in order to enhance light extraction. The shaping can be achieved through physical and/or chemical processes and may comprise various shapes or sizes.

The present invention also discloses a device having enhanced properties using the above-described structures.

BRIEF DESCRIPTION OF THE DRAWINGS

Referring now to the drawings in which like reference numbers represent corresponding parts throughout:

FIG. 1A is a cross-sectional schematic of the first nitride semiconductor device of the present invention, comprising an n-AlGaN to a p-AlGaN short-period superlattice (SPSL) TJ with a top contact that may be partially or fully transparent or reflective, and incorporating a multilayer structure below the active region, and FIGS. 1B, 1C and 1D are magnified callouts from FIG. 1A.

FIG. 2A is a cross-sectional schematic of the second nitride semiconductor device of the present invention, comprising an n-AlGaN to a 3D polarization doped p-AlGaN TJ with a top contact that may be partially or fully transparent or reflective, and incorporating a multilayer structure below the active region, and FIGS. 2B and 2C are magnified callouts from FIG. 2A.

FIG. 3A is a cross-sectional schematic of the third nitride semiconductor device of the present invention, comprising a p-GaN hole injection layer on top of a p-AlGaN SPSL with a top contact that may be partially or fully transparent or reflective, and incorporating a multilayer structure below the active region, and FIGS. 3B, 3C and 3D are magnified callouts from FIG. 3A.

FIG. 4A is a cross-sectional schematic of the fourth nitride semiconductor device of the present invention, comprising a p-GaN hole injection layer on top of a 3D polarization doped AlGaN layer with a top contact that may be partially or fully transparent or reflective, and incorporating a multilayer structure below the active region, and FIGS. 4B and 4C are magnified callouts from FIG. 4A.

FIGS. 5A and 5B are atomic force microscopy (AFM) images of a typical disc-hillock morphology observed in the multilayer structure and active region surfaces.

FIG. 6 is a cross-sectional transmission electron microscopy (TEM) image of an undulating active region.

FIG. 7 is a graph of quick test (QT) power at 20 mA (mW) vs. (102) full-width at half-maximum (FWHM) (arcsec) that shows the output power measured for LEDs grown on substrates with different AlN layer (102) FWHMs.

FIG. 8 is a flowchart illustrating a method for fabricating a device according to the present invention.

FIG. 9 is a graph of quick electroluminescence (EL) power (mW) vs. current (mA) that shows the output power measured for LEDs grown with and without the novel multilayer structure versus input current.

FIG. 10 is a graph of spectral radiant power ($\mu$W/nm) vs. wavelength (nm) that shows a comparison of typical spectral radiant power between a typical UV-C LED with a multilayer structure and a typical conventional near UV-C LED without a multilayer structure (e.g., a conventional UV LED).

FIG. 11 is an AFM image of a typical surface morphology of an active region of a conventional UV-C or near UV-C LED.

FIG. 12A is a cross-sectional schematic of a conventional UV-C LED, and FIGS. 12B and 12C are magnified callouts from FIG. 12A.

DETAILED DESCRIPTION OF THE INVENTION

In the following description of the preferred embodiment, reference is made to the accompanying drawings which form a part hereof, and in which is shown by way of illustration a specific embodiment in which the invention may be practiced. It is to be understood that other embodiments may be utilized and structural changes may be made without departing from the scope of the present invention.

Overview

The present invention describes UV light emitting III-nitride-based device structures incorporating a III-nitride-based multilayer structure (interlayer) deposited or formed on a substrate via MOCVD. The use of III-nitride-based multilayer structures incorporated into UV light emitting devices offers a means of improving the III-nitride device performance.

III-nitride-based light emitting device structures incorporating a doped multilayer structure provide a means of enhancing the performance of III-nitride-based UV light emitting LEDs by greatly enhancing the device output power at constant current, in comparison with III-nitride-based UV light emitting LEDs without the multilayer structure. The present invention discloses a III-nitride-based UV light emitting LEDs with a doped multilayer structure and discloses a means of creating such a doped multilayer structure to achieve enhanced device performance.

Technical Description

The prior art in III-nitride-based UV light emitting LEDs typically comprises an n-type region with a simple layer structure, such as one or more thick layers of uniform doping and composition. Whereas superlattices and multilayer structures are commonplace in active regions and p-type structures, they have not been applied to the n-side of the device in current state-of-the-art, commercially available III-nitride-based UV light emitting LEDs. This invention demonstrates the improved light output characteristics of III-nitride-based UV light emitting LEDs in which a doped multilayer structure has been introduced in the n-type side of the active region of the device.

Embodiment 1

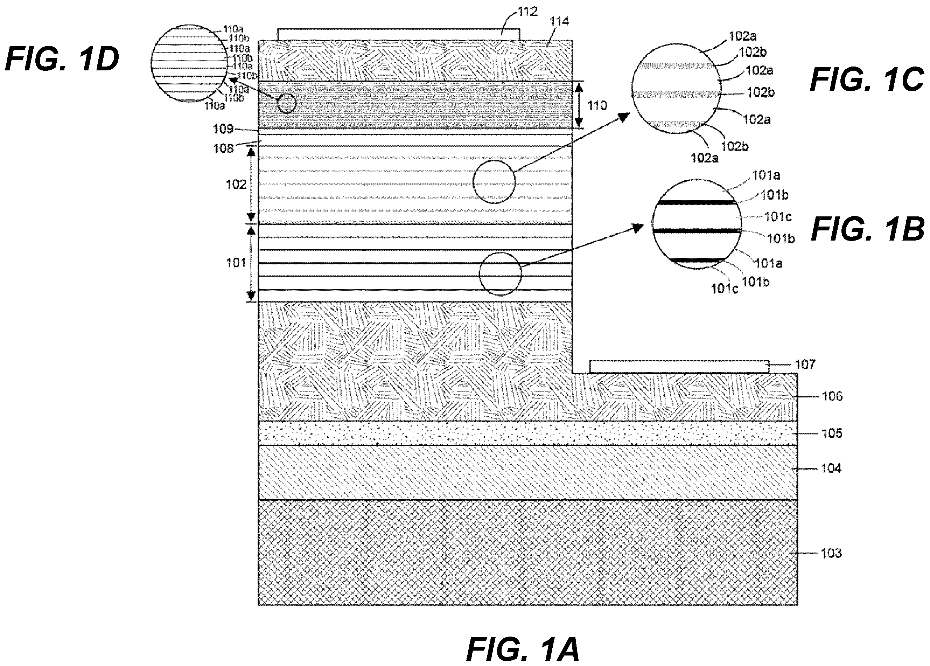

FIG. 1A is a schematic sectional view showing the structure of a III-nitride-based UV light emitting LED, according to a first embodiment of the present invention. This LED comprises a sapphire substrate 103 (e.g., either a flat or patterned sapphire substrate), and deposited successively in the following order on the substrate 103: a first buffer layer 104 made of AlN (closest to the substrate 103 surface), a second buffer layer 105 made of $Al_aGa_{1-a}N$, an n-contact or n-cladding layer 106 made of

$Al_bGa_{1-b}N$ doped with silicon, an n-side multilayer structure 101 comprised of an $Al_cGa_{1-c}N$ / $Al_dGa_{1-d}N$ / $Al_eGa_{1-e}N$ superlattice (SL) doped with silicon (with layers 101a, 101b and 101c shown in the magnified callout of FIG. 1B), an active region 102 comprising a multiple quantum well structure made of $Al_fGa_{1-f}N$ / $Al_gGa_{1-g}N$ (with layers 102a and 102b shown in the magnified callout of FIG. 1C), a UID (unintentionally doped) or p-type $Al_hGa_{1-h}N$ spacer 108, a p-type $Al_jGa_{1-j}N$ EBL 109 doped with magnesium, a p-type cladding layer 110 comprising an SPSL made of alternating layers with layers 110a and 110b of $Al_kGa_{1-k}N$ / $Al_mGa_{1-m}N$ doped with magnesium (shown in the magnified callout in FIG. 1D), a TJ transparent current spreading layer 114 made of $Al_nGa_{1-n}N$ doped with silicon, and an n-contact layer 112 that is the furthest from the substrate 103 surface, where $0 \leq a,b,c,d,e,f,g,h,j,k,m,n \leq 1$, and each of a, b, c, d, e, f, g, h, j, k, m, n can be different from one another. The n-contact layer 112 may comprise a reflective mirror contact that covers the majority (>50%) of the surface or the entire surface, where the layer is fabricated from various materials that may include metallic V, Al, Ni, Au, Ag, Pt, Pd, In, or other metals, or IZO, ITO, $MgF_2$, $SiO_2$, gallium oxide ($Ga_2O_3$) (n-type or intrinsic), or other compounds. The n-contact layer 112 may also comprise a current spreading pad that does not cover the entire top surface and supplies current to the n-type transparent TJ current spreading layer 114, where electrodes are formed to cover less than 50% of the surface to allow for light to escape out of the top surface. Also, the device has a portion where a surface of the n-side nitride semiconductor layer 106 is exposed and an n-electrode 107 composed of various materials that may include metallic V, Al, Ni, Au, Ag, Pt, Pd, In, or other metals, or IZO, ITO, $MgF_2$, $SiO_2$, $Ga_2O_3$ (n-type or intrinsic), or other compounds is formed thereon. The n-contact or n-cladding layer 112 and n-electrode 107 may be either reflective, transparent, or opaque, and similar materials may be used to coat the entire device to improve and direct the light output.

The LED device according to the first embodiment has the active region 102 with the multi quantum well structure sandwiched between an n-region including the first buffer layer 104, the second buffer layer 105, the n-contact or n-cladding layer 106, and the n-side multilayer structure 101, and a p-region including the UID or p-type spacer 108, the p-type AlGaN EBL 109, and the p-type cladding SPSL layer 110.

The nitride semiconductor device according to the first embodiment includes the n-side multilayer structure layer 101 beneath the active region 102 in the n-region, depositing, as shown in the magnified callout in FIG. 1B, one or more III-nitride semiconductor layers with different aluminum molar fractions, such as a first nitride semiconductor film 101c containing $Al_cGa_{1-c}N$, a second nitride semiconductor film 101b containing $Al_dGa_{1-d}N$, and a third nitride semiconductor film 101a containing $Al_eGa_{1-e}N$, where the compositions c, d, e may all be different from one another and are in the range $0 \leq c,d,e \leq 1$.

The films 101a, 101b, and 101c could also be formed from etchback of the underlying previous film layer instead of direct deposition, where the AlGaN alloy composition of the topmost part of the previous layer is changed with gas etching of the material. The multifilm layers 101a, 101b, and 101c could also be doped with silicon, germanium, or other elements, at a concentration below $10^{21}$ cm$^{-3}$. The n-side multilayer structure 101 includes at least one of each of the first nitride semiconductor film 101c and the second nitride semiconductor film 101b in an example stack 101c/101b, and preferably includes the third nitride semiconductor film 101a as well as more than two total repetitions of the structure such as in an example stack of (101c/101b/101a/101b) repeated three times. The n-side multilayer structure 101 can be any combination of the layers 101c, 101b, and 101a, in any particular order. More or less layers of different compositions or thicknesses can also be incorporated.

In one embodiment, the n-side multilayer structure 101 comprises a sequence of 101b/101c/101b/101a/101b/101c/101b/101a/101b/101c/101b/101a/101b, or in shorthand notation, (101/b/101c/101b/101a) $\times$ 3 + 101b.

Where the n-side multilayer structure 101 is formed in contact with the active region 102, one of the nitride semiconductor films 101a, 101b, or 101c is held in contact with an initial layer (a well or a barrier layer) of the active region 102. This layer may be any of the layers 101a, 101b, 101c, or additional included layers.

Additionally, even though the n-side multilayer structure 101 is formed in direct contact with the active region 102 in the illustrated embodiment, another layer made of an n-type nitride semiconductor may intervene between the n-side multilayer structure 101 and the active region 102.

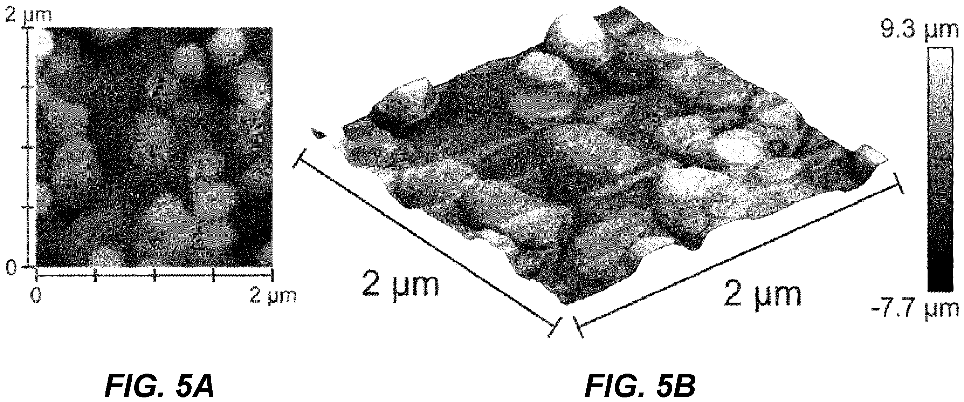

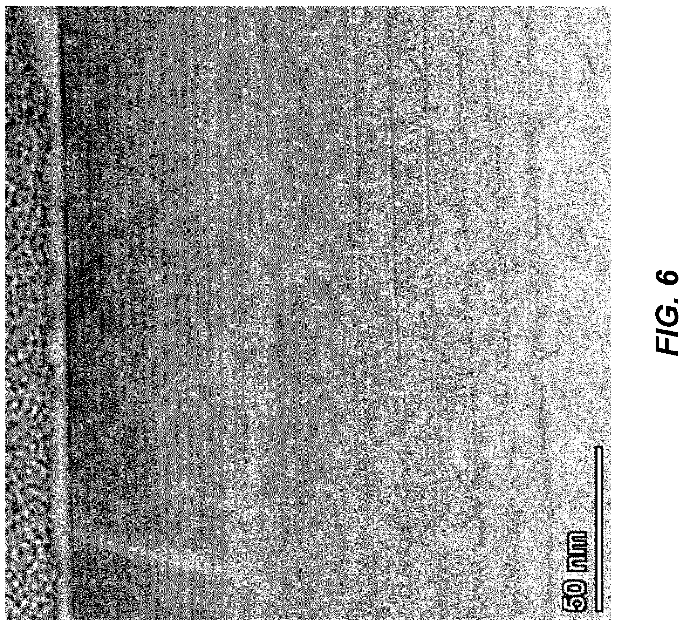

In a preferred embodiment, at least one first nitride semiconductor film 101a, and/or at least one second nitride semiconductor film 101c, may have a film thickness not greater than 300 angstroms, preferably not greater than 150 angstroms. At least one third nitride semiconductor film 101b may have a film thickness not greater than 150 angstroms, preferably not greater than 50 angstroms, and more preferably not greater than 20 angstroms. The n-side multilayer structure 101 may be as follows: (101b/101c/101b/101a) $\times$ n + 101b, where n may be less than 20, preferably less than 10, and more preferably between 1 and 8. The film 101b would preferably be formed by gas etchback of underlying films (either 101a, 101c, or whatever layer is immediately below) to form a thin, high Al content layer. The compositions of the films 101a/101b/101c may be in the range of $0.5 \leq c,d,e \leq 1$ for UV-C LEDs, and more preferably in the range of $0.55 \leq c,d,e \leq 0.85$ for 101a and 101c and in the range of $0.7 \leq c,d,e \leq 1$ for 101b. The nitride semiconductor films 101a/101b/101c may be doped with silicon at a concentration below $10^{21}$ cm$^{-3}$, and more preferably in the range of $10^{17}$ to $10^{20}$ cm$^{-3}$. When different numbers of each of the films 101a, 101b, and 101c are deposited with controlled thicknesses, and with control of the deposition parameters in MOCVD such as ammonia flow, etchback conditions for 101b, growth rate, growth duration, doping concentration of Si, metalorganic flow, etc., different surface morphologies and crystal qualities can be achieved in and above the n-side multilayer structure 101. When the films 101a, 101b, and 101c have thicknesses, doping, and compositions within the above-mentioned range, the crystal quality and radiative recombination rate of emitting nitride semiconductor film layers deposited on such a n-side multilayer structure 101 can be drastically improved, due to the improvements on the crystal quality and growth morphology of the n-side multilayer structure 101. The n-side multilayer structure 101 thus provides the ability to fine-tune and control the surface morphology and crystal quality, to achieve a specific targeted surface morphology and crystal quality in the active region 102 to be grown above, and also to achieve an undulating active region 102. One preferred targeted surface morphology in the n-side multilayer structure 101 and undulating active region 102 is detailed in FIGS. 5A, 5B and 6 and is defined as a "disc-hillock" morphology. The disc-hillocks are circular or elliptical nano-discs, with near-atomically flat (below 2 nm root mean square (RMS) roughness, or more preferably below 1 nm RMS roughness) surfaces, and between 50 to 1000 nm in length and width. The discs are between 1 nm and 20 nm tall relative to the surrounding area, and form elevated regions that are locally extremely smooth, enabling well-defined quantum well structures to be grown on top of the discs, and thus increasing the output capability of the device. Over a wider region, the locally flat disc-hillocks undulate up and down, creating a surface morphology with an average RMS roughness of between 0.5 to 15 nm, or more preferably between 1 to 5 nm, over a 2 $\mu$m by 2 $\mu$m region, but comprises local regions at least 100 nm by 100 nm in size with an RMS roughness of less than 1 nm. The RMS roughness over a large area is defined as the undulating amplitude and should be at least 0.5 nm for the effects of the undulating morphology to be realized. This undulating active region 102 may improve the light emission efficiency of the device due to electron and hole localization from the disc-hillocks, and extremely smooth surfaces on top of the disc-hillocks enable sharp quantum well heterostructures which increase carrier localization further.

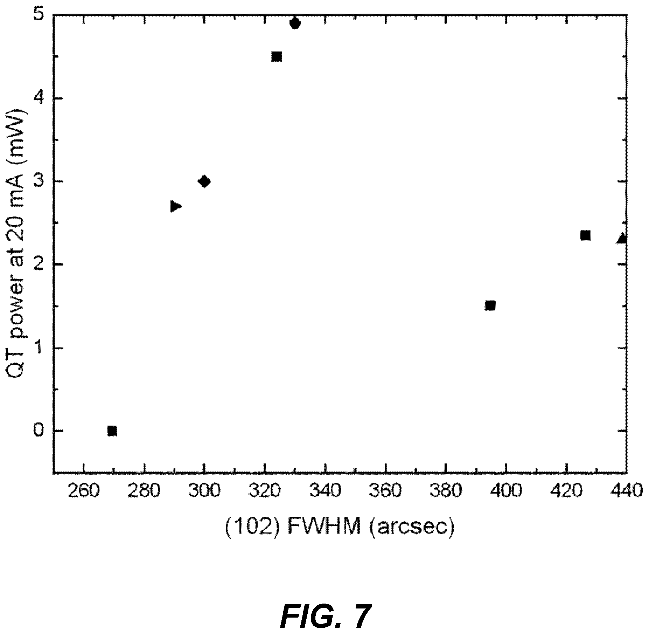

The crystal quality of the first buffer layer 104 made of AlN is extremely important to LED performance, as crystallographic defects can act as non-radiative recombination centers and decrease the light output efficiency in high enough concentrations. Crystal quality can be estimated with an x-ray diffraction (102) peak rocking curve full width at half-maximum (RC FWHM) measurement, which correlates with the dislocation density of the material. In material with a (102) peak RC FWHM that is above 500 arcseconds, the dislocation density is too high, and electrons and holes are unable to travel far without interacting with a defect and recombining without emitting light, thus causing a decrease in efficiency. In material with a (102) peak RC FWHM that is below 150 arcseconds, the preferred undulating disc-hillock crystal growth morphology may be unable to be achieved. This limits LED performance due to the lack of the beneficial carrier localization effects from the desired undulating disc-hillock morphology. LED power output versus (102) RC FWHM is detailed in FIG. 7, and a maximum in LED output power is observed for RC FWHM of the AlN buffer layer 104 between 250 and 330 arcseconds. A decrease in LED output power is observed at very low (200 arcseconds) and very high (440 arcseconds). Thus, it is preferred that the (102) RC FWHM of the AlN buffer layer 104 be between 150 and 500 arcseconds or dislocation density between $1 \times 10^7$ to $1 \times 10^{10}$ cm$^{-2}$.

In a second preferred embodiment, the nitride semiconductor films 101a, 101b, and 101c may have different thicknesses, doping, and/or compositions. For example, at least one of the first/second/third nitride semiconductor films $101a_i$/$101b_i$/$101c_i$ can have a film thickness, doping concentration, and/or alloy composition of AlGaN different from that of the next neighboring first/second/third nitride semiconductor films $101a_{i-1}$/$101b_{i-1}$/$101c_{i-1}$ and $101a_{i+1}$/$101b_{i+1}$/$101c_{i+1}$ (i.e., the thickness of the film $101a_i$/$101b_i$/$101c_i$ can be different from the thicknesses of the films $101a_{i-1}$/$101b_{i-1}$/$101c_{i-1}$ and $101a_{i+1}$/$101b_{i+1}$/$101c_{i+1}$ which are respectively below and above the film $101a_i$/$101b_i$/$101c_i$ in the sequence of first/second/third nitride semiconductor films). By way of further example, assuming that the first nitride semiconductor film 101a is made of a lower Al composition AlGaN and the second nitride semiconductor film 101c is made of a higher Al composition AlGaN (the third nitride semiconductor film 101b is assumed to be a constant thickness, doping, and composition throughout the n-side multilayer structure 101), the individual layers $101a_i$ and $101c_i$ closer to the n-AlGaN cladding 106 may have a varying film thickness either increasing or decreasing as the distance from the layers $101a_i$ and $101ci$ to the active region 102 decreases. In so doing, the n-side multilayer structure 101 can have a varying index of refraction with the nitride semiconductor films $101a_i$ and $101b_i$ having varying indexes of refraction resulting in an average increase or decrease in the index of refraction between the n-AlGaN cladding 106 and active region 102. Thus, the n-side multilayer structure 101 can exhibit substantially the same effects as those of a continuous grading composition nitride semiconductor layer while retaining its ability to control the crystal quality and surface morphology. Accordingly, in a semiconductor device such as a semiconductor laser of a type requiring the use of a beam waveguide, the n-side multilayer structure 101 can operate as a beam waveguide to adjust the mode of the laser beam.

In a third preferred embodiment, the first and second nitride semiconductors layers 101a and 101c can be made of the same semiconductor material with similar thicknesses, while the layer 101b can be formed through the gas etching of the layers 101a and 101c resulting in a much thinner layer 101b. The thickness of layers of type 101a and 101c may be between 50 and 300 angstroms, while the thickness of layers of type 101b may be between 1 and 20 angstroms. This creates a single layer with effectively a singular composition with only very slight deviations, but with the thin layers 101b and controlled doping of Si throughout the structure 101, allow for control of the growth morphology and crystal quality similar to previously detailed preferred embodiments.

In the practice of the first, second, and third preferred embodiment, one, two, or all of the three nitride semiconductor films 101a/101b/101c may be either undoped or doped with n-type impurities such as Si and Ge. To enhance the crystal quality, the first and second nitride semiconductor films 101a, 101b, and 101c are preferably doped with silicon at a concentration below $10^{21}$ cm$^{-3}$, and more preferably in the range of $10^{17}$ to $10^{20}$ cm$^{-3}$. The layers 101a/101b/101c may also be doped with a varying or constant concentration through the individual layers, and throughout the entire structure 101. For example, the doping of layers of type 101a, 101b, or 101c closer to the n-AlGaN cladding 106 may have a lower or higher average concentration compared with layers closer to the active region 102, and individual layers 101a, 101b, or 101c may have a linear grading ramp where the dopant concentration linearly increases or decreases throughout the individual layers.

In the practice of the first, second and third preferred embodiment, the p-type cladding layer 110 that is an SPSL comprises alternating nitride semiconductor layers 110a and 1 10b, wherein the thickness of these layers may be below 100 angstroms, preferably below 50 angstroms, and more preferably below 30 angstroms. The composition of one of the layers 110a and 110b may be $Al_xGa_{1-x}N$ where $0 \le x \le 0.5$, or more preferably $0 \le x \le 0.3$, and the other of the layers 110a and 110b may be $Al_yGa_{1-y}N$ where $0.5 \le y \le 1$, or more preferably $0.7 \le x \le 1$. The layers 110a and 110b may be p-type doped with preferably Mg, or alternatively Be or other elements, to a concentration in the range of $10^{16}$ to $10^{21}$ cm$^{-3}$, or more preferably $10^{18}$ to $10^{20}$ cm$^{-3}$.

The EBL 109 comprises $Al_xGa_{1-x}N$ where $0.6 \le x \le 1$, with a thickness of between 2 to 20 nm, and may be p-type doped with preferably Mg, or alternatively Be or other elements, to a concentration in the range of $10^{16}$ to $10^{21}$ cm$^{-3}$, or more preferably $10^{18}$ to $10^{20}$ cm$^{-3}$.

Embodiment 2

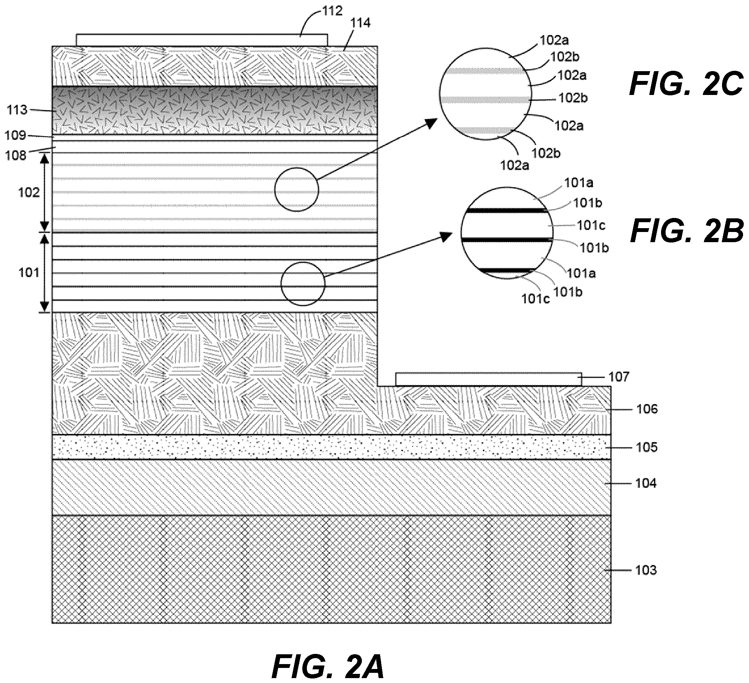

The nitride semiconductor light emitting device according to embodiment 2, as shown in FIG. 2A (wherein FIGS. 2B and 2C are magnified callouts of layers 101a, 101b and 101c, and 102a and 102b, respectively), has the same structure as in embodiment 1 except that the p-type cladding layer 110 in embodiment 2 comprises a 3D polarization doped nitride semiconductor layer 113, thereby substituting for the p-type cladding layer 110 that is an SPSL described in embodiment 1.

The 3D polarization doped nitride semiconductor layer comprises a layer of $Al_xGa_{1-x}N$ of thickness less than 300 nm where $0 \le x \le 1$, where the composition throughout the layer can be constant or varied. A possibility for a varied composition profile would be a linearly increasing or decreasing Al composition between the start of the layer 113 (just above layer 109), to the end of the layer 113 (just below layer 114). The layer may also be undoped, or doped with Mg, Be, or other elements, at an average concentration between $10^{16}$ to $10^{21}$ cm$^{-3}$. The doping concentration profile may be constant or varied throughout the layer. Some examples of possible varied doping concentration profiles are a linearly increasing or decreasing amount of dopant, or a constant low or zero doping concentration for most of the layer with a few thin (less than 10 nm thick) sheets of extremely high concentrations (delta doping).

A preferred embodiment would be where the composition of the layer 113 is linearly graded from $Al_xGa_{1-x}N$ where $0.7 \le x \le 1$ at the boundary between layers 109 and 113 to $Al_yGa_{1-y}N$ where $0 \le y \le 0.5$ at the boundary between layers 114 and 113.

Embodiment 3

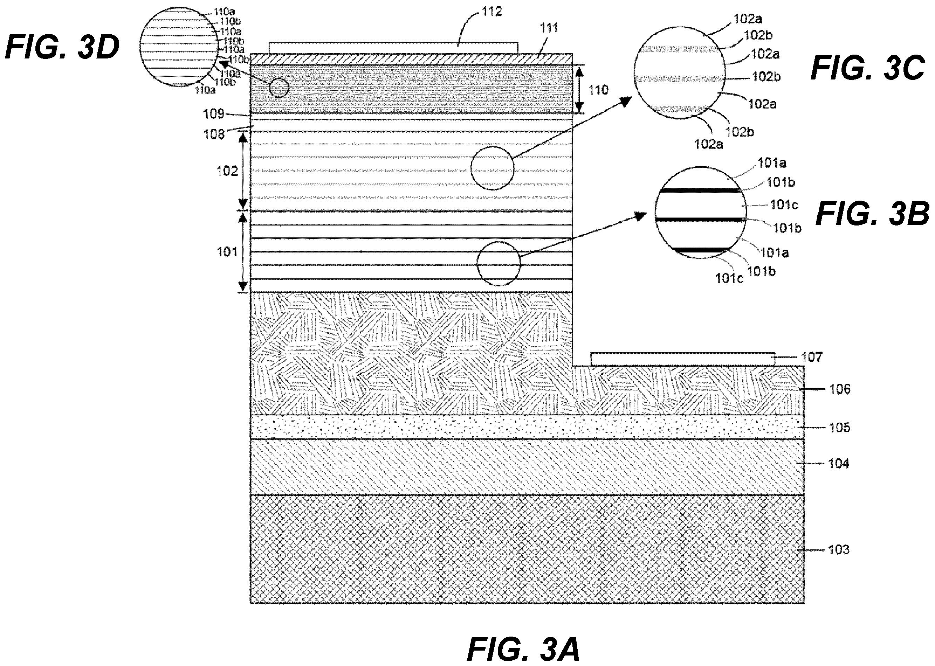

The nitride semiconductor light emitting diode according to embodiment 3, as shown in FIG. 3A (wherein FIGS. 3B, 3C and 3D are magnified callouts of layers 101a, 101b and 101c, 102a and 102b, and 110a and 110b, respectively), has the same structure as embodiment 1, except that the TJ current spreading n-type layer 114 is replaced with a p-type doped $Al_xGa_{1-x}N$ hole injection layer 111 of thickness less than 500 nm where the composition is $0 \le x \le 0.7$, or more preferably of a thickness between 5 and 50 nm and a composition $0 \le x \le 0.3$, and that the n-contact layer 112 is now replaced with a p-contact layer to the p-type hole injection layer 111, which similar to the n-contact layer 112 in embodiment 1, may comprise a reflective mirror contact that covers the majority (>50%) of the surface or the entire surface, where the layer is fabricated from various materials that may include metallic V, Al, Ni, Au, Ag, Pt, Pd, In, or other metals, or IZO, ITO, $MgF_2$, $SiO_2$, $Ga_2O_3$ (n-type or intrinsic), or other compounds. The p-contact layer 112 may also comprise a current spreading pad that does not cover the entire top surface and supplies current to the p-type hole injection layer 114, where electrodes are formed to cover less than 50% of the surface to allow for light to escape out of the top surface.

The p-type doped hole injection layer 111 may fully or partially cover the p-type cladding layer 110 below. A partial coverage hole injection layer where less than 70% of the p-type cladding layer 110 surface is covered by the hole injection layer 111 may enhance light output due to the light absorptive effects of the low Al content hole injection layer 111. A full coverage hole injection layer 111 may enhance light output due to the increased number of supplied hole carriers for recombination and light emission in the active region 102.

### Embodiment 4

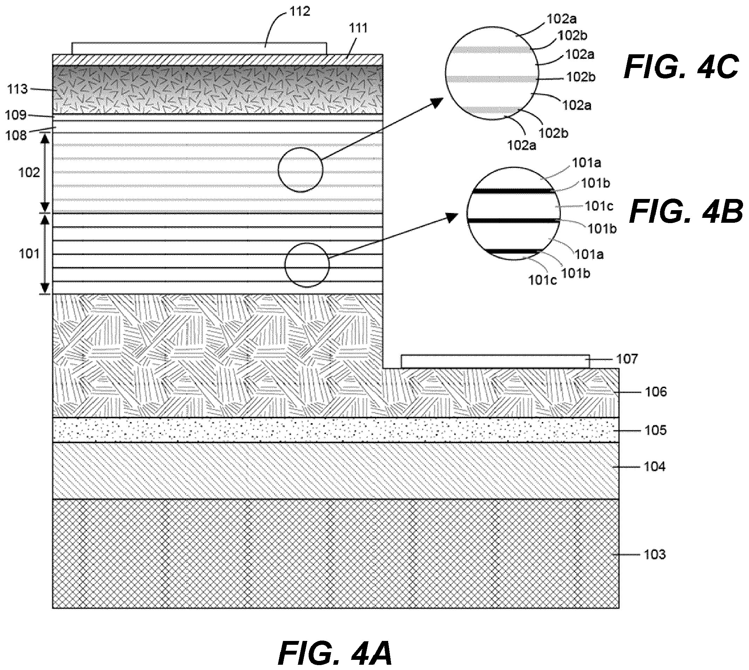

The nitride semiconductor light emitting diode according to embodiment 4, as shown in FIG. 4A (wherein FIGS. 4B and 4C are magnified callouts of layers 101a, 101b and 101c, and 102a and 102b, respectively), has the same structure as embodiment 2 except that the TJ current spreading n-type layer 114 is replaced with a p-type doped $Al_xGa_{1-x}N$ hole injection layer 111 of thickness less than 500 nm where the composition is $0 \leq x \leq 0.7$, or more preferably of a thickness between 5 and 50 nm and a composition $0 \leq x \leq 0.3$. Also, similar to embodiment 3, the n-contact layer 112 (as in embodiment 1) is replaced with a p-contact layer 112 to act as a p-contact to the p-type hole injection layer 111.

Similar to embodiment 3, the p-type doped hole injection layer 111 may fully or partially cover the p-type cladding layer 110 below. A partial coverage hole injection layer where less than 70% of the p-type cladding layer 110 surface is covered by the hole injection layer 111 may enhance light output due to the light absorptive effects of the low Al content hole injection layer 111. A full coverage hole injection layer 111 may enhance light output due to the increased number of supplied hole carriers for recombination and light emission in the active region 102.

### Process Steps

### Example 1

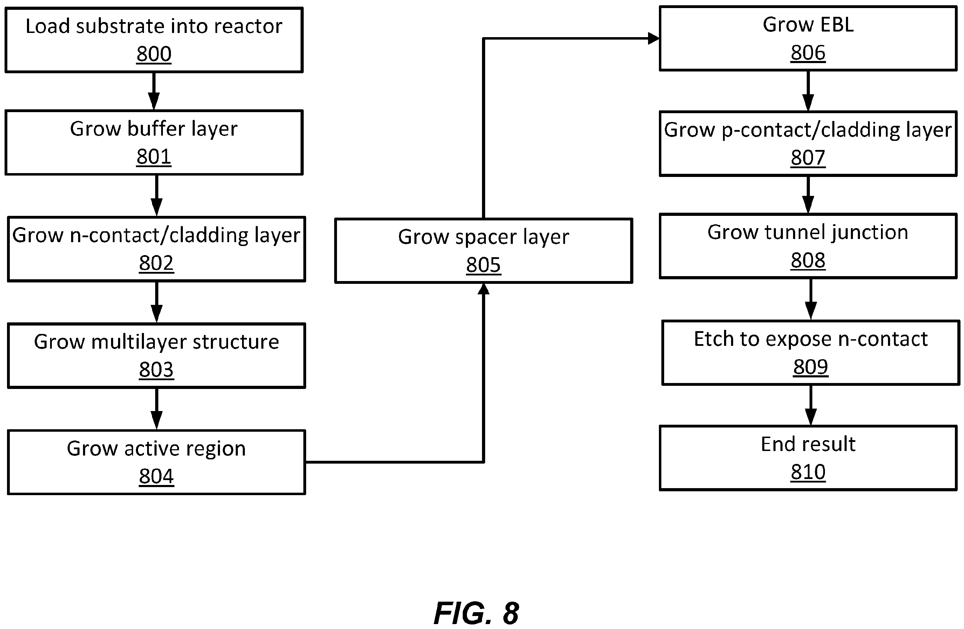

Example 1 describes a method for fabricating the first embodiment of the present invention and is illustrated by reference to FIGS. 1A and 8.

Block 800 represents a first step where a substrate 103 is loaded in a reactor and cleaned. In Example 1, a C-face sapphire substrate 103 is set in the MOCVD reactor, and the temperature of the substrate 103 is increased to 1000-1400°C with ammonia flow to clean the substrate 103. Instead of a C-face sapphire substrate 103, the substrate 103 may include a C-face AlN layer pre-deposited on a sapphire substrate 103 prepared with sputtering and annealing, another MOCVD reactor, or other material deposition technique. The sapphire substrate 103 may or may not be patterned to improve light extraction in the final UV LED. The substrate 103 may also have its principal surface represented by an R-, A-, M-, or other crystallographic face. The substrate 103 may also be composed of other materials, for example, SiC (including 6H, 4H or 3C), Si, ZnO, GaAs, GaN, AlN, BN, $Ga_2O_3$, spinel $(MgAl_2O_4)$, or some other material, and may or may not have a pre-deposited layer of AlN deposited from a separate MOCVD reactor or other material deposition tool.

Block 801 represents a step where, subsequent to the ammonia substrate cleaning, a first buffer layer 104 made of AlN which has a thickness of about 150 nm is grown on the substrate 103, using hydrogen as a carrier gas, and ammonia and TMA (trimethylaluminum) as material gasses. Such a buffer layer 104 may be omitted, depending on the kind of the substrate, the growing method, etc.

Block 802 represents a step where, after growing the buffer layer 104, the flow of TMA is stopped, the flow of ammonia is changed to match the condition for the growth of the next layer 105, and the temperature is decreased to 1250°C. A second buffer layer 105, made of $Al_xGa_{1-x}N$ where $0.6 \leq x \leq 1$ (preferably x = 0.85), is then deposited using ammonia, TMG (trimethylgallium), and TMA as material gasses, and TMI (trimethylindium) as a surfactant to improve the morphology. Such a buffer layer 105 may also be omitted, depending on the kind of the substrate, the growing method, etc. After growing the second buffer layer 105, the flows of TMA, TMG, and TMI are stopped, the ammonia flow is changed to match the condition for the growth of the next layer 106, and the temperature is decreased to 1200°C. An n-type contact or cladding layer 106, made of $Al_xGa_{1-x}N$ where $0.4 \leq x \leq 1$ (preferably x = 0.65) and doped with Si to a concentration preferably of $5 \times 10^{19}/cm^3$ is grown using ammonia, TMG, and TMA as material gasses, TMI as a surfactant, and silane or disilane gas as a dopant gas. An ultralow ammonia flow condition may be used to grow the n-type contact or cladding layer 106, as it may improve the electrical characteristics of the n-type contact or cladding layer 106. Ultralow ammonia flow is defined here as having a V/III ratio, or ratio of ammonia gas flow to total metal organic flow, being below 100.

The thickness of the n-contact layer or cladding 106 is not specifically limited to any thickness, but if an ultralow ammonia flow condition is used, the thickness should preferably be between 100 to 1000 nm, due to strain and material growth effects compromising the material surface quality above thicknesses of 1000 nm. Moreover, the n-type impurity (preferably Si, but may also be Ge or other elements) may be desirably doped in with a high concentration to the degree that the crystal quality and electrical characteristics of the nitride semiconductor is not deteriorated and preferably in the concentration between $1 \times 10^{18}/cm^3$ and $5 \times 10^{21}/cm^3$.

Block 803 represents a next step where the temperature is maintained at 1200°C and a first nitride semiconductor film (layer 101b), made of n-doped $Al_xGa_{1-x}N$ where $0.6 \leq x \leq 1$ and having a thickness of between 5 and 20 Angstroms, is grown using TMA, TMG, and ammonia as material gasses, disilane or silane as a dopant gas, and TMI as a surfactant. This layer may also (preferably) be created with etchback under hydrogen carrier gas, ammonia, and TMI, of the top surface of the previous layer (in this case, this would be the n-type contact or cladding layer 106), by etching out some Ga and decreasing the Ga composition, after shutting off the flow of disilane/silane, TMA, and TMG while keeping the flow of ammonia, hydrogen carrier gas, and TMI unchanged. Subsequently, if TMA, TMG, and disilane/silane were shut off, they are now turned back on, and a second nitride semiconductor film (layer 101c) made of n-doped $Al_xGa_{1-x}N$ where $0.4 \leq x \leq 1$ (preferably 0.6) of thickness between 50 and 300 Angstroms (preferably 140 Angstroms) is deposited. After this step, another layer 101b is deposited in a similar manner as previously described, via etchback of a thin region of layer 101c or via material growth with material gasses. Then, a layer 101a, which is similar to layer 101c, comprising n-doped $Al_xGa_{1-x}N$ where $0.4 \leq x \leq 1$, but may have a different composition compared to layer 101c (preferably 0.8), is deposited in a similar manner to how layer 101c was deposited. For layer 101a, the TMA and TMG may be changed from the deposition condition of layer 101c to account for any compositional differences between the two layers. After layer 101a is deposited, another layer 101b is deposited. These operations, which form a structure 101 of 101b/101c/101b/101a, may then be repeated any number of times, and may also include an incomplete repetition and end on any one of the layers 101a, 101b, 101c to form the n-side multilayer structure 101 (preferably repeated three times plus an additional deposition of layer 101b, for example). The n-type impurity (preferably Si but may also be Ge or other elements) may be desirably doped in a concentration throughout the structure 101 between $1 \times 10^{17}/cm^3$ and $1 \times 10^{20}/cm^3$, and more preferably between $5 \times 10^{17}/cm^3$ and $5 \times 10^{19}/cm^3$.

Block 804 represents a next step where the temperature is maintained at 1200°C and a quantum well (layer 102b) made of $Al_xGa_{1-x}N$ where $0 \leq x \leq 1$ (preferably x = 0.4 to 0.6 for UV-C emission) which may or may not be n-type doped having a thickness between 5 and 100 angstroms (preferably 15 angstroms) is grown using TMG, TMA, and ammonia as material gasses, TMI as a surfactant, and disilane or silane as a n-type dopant (if doped). Subsequently, a quantum barrier (layer 102a) made of $Al_xGa_{1-x}N$ where $0 \leq x \leq 1$ (preferably x = 0.6 to 0.9 for UV-C emission) which may or may not be n-type doped having a thickness between 50 and 500 angstroms (preferably 140 angstroms) is grown using TMG, TMA, and ammonia as material gasses, TMI as a surfactant, and disilane or silane as a n-type dopant (if doped). Additional possible etchback layers similar to layer 101b may or may not be employed between the quantum well and quantum barrier layers 102a, 102b. A total of between 1 and 20 pairs (preferably 6 pairs) of quantum well and quantum barrier layers 102b/102a are formed, preferably finishing on a quantum barrier layer 102a. Thus, the active region 102 is formed. The active region 102 may be grown with the well layer 102b first and the barrier layer 102a last, or the order may begin with the barrier layer 102a and end with the well layer 102b. Thus, the order of depositing the barrier and well layers 102a, 102b is not specifically limited to a particular order. If the quantum well and quantum barrier layers 102b, 102a are doped, the n-type impurity (preferably Si, but may also be Ge or other elements) may be desirably doped in a concentration throughout the active region 102 between $1 \times 10^{17}/cm^3$ and $1 \times 10^{20}/cm^3$.

Block 805 represents a next step where the temperature is maintained at 1200°C, and using TMG, TMA, and ammonia as material gasses, TMI as a surfactant, disilane or silane as a n-type dopant (if n-type doped), or cyclopentadienyl magnesium ($Cp_2Mg$) as a p-type dopant (if p-type doped), a spacer layer 108 made of $Al_xGa_{1-x}N$ where $0 \leq x \leq 1$ (preferably x = 0.6 to 0.9 for UV-C emission) which may or may not be n-type doped having a thickness between 50 and 500 angstroms (preferably 140 angstroms) is grown. If doped, the n-type impurity (preferably Si, but may also be Ge or other elements) or p-type impurity (preferably Mg, but may also be Be or other elements) may be desirably doped in a concentration throughout the spacer layer 108 between $1 \times 10^{17}/cm^3$ and $1 \times 10^{20}/cm^3$. The spacer layer 108 may improve the separation of p-type dopant atoms between the region with p-type doping (layers 109 and 110) and n-type doping, and/or improve the positioning of the p-n junction such that maximal carrier recombination occurs in the quantum well layers, improving LED light output and performance.

Block 806 represents a next step where the temperature is maintained at 1200°C, and using TMG, TMA, and ammonia as material gasses, $Cp_2Mg$ as a p-type dopant gas, and TMI as a surfactant, a nitride semiconductor film 109, made of p-type doped $Al_xGa_{1-x}N$ where $0 \leq x \leq 1$ (preferably x = 0.7 to 0.9 for UV-C emission) which had a thickness of between 20 and 200 angstroms (preferably 50 angstroms) was grown. This layer 109 acts as an electron blocking layer, and maximizes radiative recombination in the active layer 102. The layer 109 may also contain B or Sc, in an alloy $Sc_jGa_nAl_xB_zN$ where $0 \leq j \leq 1$, $0 \leq n \leq 1$, $0 \leq x \leq 1$, $0 \leq z \leq 1$, and $j + n + x + z = 1$. The p-type impurity (preferably Mg but may also be Be or other elements) may be desirably doped in a concentration throughout the electron blocking layer 109 between $1 \times 10^{18}/cm^3$ and $1 \times 10^{21}/cm^3$.

Block 807 represents a next step where the temperature is maintained at 1200°C, and using TMG, TMA, and ammonia as material gasses, $Cp_2Mg$ as a p-type dopant gas, and TMI as a surfactant, a nitride semiconductor layer 110 is grown for a p-type contact or cladding layer. To form layer 110, a nitride semiconductor layer 110a composed of p-type $Al_xGa_{1-x}N$ where $0 \leq x \leq 1$ (preferably $0.5 \leq x \leq 1$, and more preferably $0.7 \leq x \leq 0.9$) with thickness between 3 and 30 angstroms (preferably between 5 and 20 angstroms) is first deposited with the above-mentioned reactants. Then, the flow of the material gasses are adjusted, and a nitride semiconductor layer 110b composed of p-type $Al_xGa_{1-x}N$ where $0 \leq x \leq 1$ (preferably $0 \leq x \leq 0.5$, and more preferably $0.1 \leq x \leq 0.3$) with thickness between 3 and 30 angstroms (preferably between 5 and 20 angstroms) is deposited. Subsequently, layers 110a and 110b are deposited in an alternating manner, with a total number of layers between 10 and 80 layers, preferably between 20 and 60 layers. The p-type contact or cladding layer 110 may be grown with the layer 110a first and the layer 110b last, 110b first and 110a last, or may begin and end with both 110b or 1 10a. Thus, the order of depositing the layers 110a and 110b is not specifically limited to a particular order throughout the p-contact layer 110. The p-type impurity (preferably Mg but may also be Be or other elements) may be desirably doped in a concentration throughout the p-type contact layer 110 between $1 \times 10^{17}/cm^3$ and $1 \times 10^{21}/cm^3$.

Block 808 represents a next step where an n-type tunnel junction layer 114 is deposited at a temperature between 600 to 1400°C, using TMG, TMA, and ammonia as material gasses, silane or disilane as a n-type dopant gas, and TMI as a surfactant, with composition $Al_xGa_{1-x}N$ where $0 \leq x \leq 1$. The thickness should be preferably below 500 nm. The n-type impurity (preferably Si but may also be Ge or other elements) may be desirably doped in a concentration throughout the tunnel junction layer 114 between $1 \times 10^{17}/cm^3$ and $1 \times 10^{21}/cm^3$.

Block 809 represents a final step where a region of the device is etched to expose the n-contact layer 106. Electrodes 112 and 107 are then formed or bonded on top of the exposed region of layer 106 and on top of layer 114. The electrodes 112 and 107 may contain metals such as V, Al, Ni, Au, Ag, Pt, Pd, In, or other metals, and/or may contain $Ga_2O_3$, IZO, ITO, and/or other semiconductor or dielectric materials. The electrodes may be annealed at elevated temperatures.

During the device fabrication process, after the device growth by MOCVD or MBE, the device processing temperature should preferably be below 1000°C (or more preferably 750 °C), in order to minimize relaxation and intermixing between the layers in the hetero-interface of the p-side layers, especially layer 110, or the Mg-doped $Al_xGa_{(1-x)}N$ / Mg-doped $Al_yGa_{(1-y)}N$ (x>y) SPSL, and prevent the structural or crystallographic degradation of all layers and/or passivation of the p-type doped layers (109, 110, 113, 111).

Block 810 represents an end result, namely, an optoelectronic device, such as an LED comprised of one or more nitride semiconductor layers containing aluminum, such as $Al_xGa_{1-x}N$ alloys where $0 \leq x \leq 1$, including an active region 102 having a single or multiple quantum well structure emitting at a UV wavelength, and at least one cladding layer. An n-side multilayer structure 101 is located adjacent to the active region 102 of the LED, wherein the n-side multilayer structure 101 contains layers one or more layers 101a, 101b, 101c, with a higher aluminum composition as compared to adjacent layers 101a, 101b, 101c, the active region 102 and/or the cladding layer.

The n-side multilayer structure 101 provides an ability to fine-tune and control surface morphology and crystal quality, to achieve a specific targeted surface morphology and crystal quality in the active region 102. Specifically, the n-side multilayer structure 101 may be used to achieve an undulating active region 102.

The n-side multilayer structure 101 comprises one or more nitride semiconductor layers 101a, 101b, 101c, with different aluminum molar fractions, such as $Al_xGa_{1-x}N$ where $0 \leq x \leq 1$, $Al_yGa_{1-y}N$ where $0 \leq y \leq 1$, and $Al_zGa_{1-z}N$ where $0 \leq z \leq 1$.

The nitride semiconductor layers 101a, 101b, 101c are undoped, unintentionally doped, doped, and/or modulation doped, with a doping concentration adjusted to be $5 \times 10^{21}/cm^3$ or less and n-type when the nitride semiconductor layers 101a, 101b, 101c, are doped or modulation doped.

The nitride semiconductor layers 101a, 101b, 101c, are formed in a repeating pattern, and may differ in thickness, wherein at least one of the nitride semiconductor layers 101a, 101b, 101c, has a thickness of less than 200 angstroms, and the n-side multilayer structure layer 101 has a total thickness of less than 500 nm.

The n-side multilayer structure 101 is adjacent an n-side of the active region 102 and, optionally, the n-side multilayer structure 101 is in contact with the active region 102.

At least one of the nitride semiconductor layers, such as an AlN buffer layer 104, an n-AlGaN cladding layer 106, and/or the n-side multilayer structure 101, has a (102) rocking curve full width at half-maximum of between 150-500 arcseconds or dislocation density between $1 \times 10^7$ to $1 \times 10^{10}$ cm$^{-2}$. This condition should mostly likely apply to the AlN buffer layer 104, although the n-AlGaN cladding 106 and n-side multilayer structure 101 may also be in this range, but on the higher side, e.g., a (102) rocking curve full width at half-maximum of between 150-900 arcseconds and/or a dislocation density between $1 \times 10^7$ to $1 \times 10^{10}$ cm$^{-2}$, due to increasing defects from strain, lattice mismatch, Si doping, etc.

The device also comprises: a p-cladding layer that is a SPSL made of alternating layers of $Al_kGa_{1-k}N$ and $Al_mGa_{1-m}N$ doped with magnesium, where $0 \leq k \leq 1$ and $0 \leq m \leq 1$; a 3D polarization doped nitride semiconductor layer grown on or above a p-type nitride semiconductor layer of the LED; a tunnel junction grown on or above a p-type nitride semiconductor layer of the LED, wherein the tunnel junction comprises an n-type nitride semiconductor layer; and/or a p-type doped $Al_xGa_{1-x}N$ hole injection layer grown on or above a III-nitride semiconductor layer of the LED.

Example 2

Example 2 describes a method for fabricating the second embodiment of the present invention and is illustrated by reference to FIGS. 2A and 8. The fabrication process in Example 2 is the same as in Example 1, except for the p-contact layer: layer 110 in Example 1 is replaced with layer 113 in Example 2. Layer 113 is a nitride semiconductor polarization doped p-type contact layer. To form layer 113, a nitride semiconductor layer composed of p-type $Al_xGa_{1-x}N$ where $0 \leq x \leq 1$ and where the composition varies throughout the layer (for example, in a preferably linearly increasing or decreasing manner) is grown using TMG, TMA, and ammonia as material gasses, $Cp_2Mg$ as a p-type dopant gas (optional), and TMI as a surfactant. The polarization doped layer 113 may be undoped, doped with a constant concentration of preferably Mg (or Be or other elements) below a concentration of $1 \times 10^{21}/cm^3$, or doped with a varying concentration of preferably Mg (or Be or other elements) between a concentration of $1 \times 10^{17}/cm^3$ to $1 \times 10^{21}/cm^3$.

Example 3

Example 3 describes a method for fabricating the third embodiment of the present invention and is illustrated by reference to FIGS. 3A and 8. The fabrication process in Example 3 is the same as in Example 1, except for the n-type TJ layer 114. In Example 3, the layer 114 is replaced with a p-type contact layer 111 composed of p-type doped $Al_xGa_{1-x}N$ where $0 \leq x \leq 1$, preferably $0 \leq x \leq 0.2$. This layer is deposited at a temperature between 800 to 1200°C (preferably 1050°C) using TMG, TMA, and ammonia as material gasses, $Cp_2Mg$ as a p-type dopant gas, and (optionally) TMI as a surfactant, and doped with a concentration of preferably Mg (or Be or other elements) between $1 \times 10^{17}/cm^3$ and $1 \times 10^{21}/cm^3$. The thickness of this layer should be thicker than 50 angstroms, and preferably should be approximately 200 angstroms. The layer 111 may completely cover the immediate layer 110 beneath it, or may also be grown in a patchy island morphology that does not cover the entire surface, preferably covering less than 70% of the available surface area of layer 110 (or whichever layer is immediately below that layer).

Example 4

Example 4 describes a method for fabricating the fourth embodiment of the present invention and is illustrated by reference to FIGS. 4A and 8. The fabrication process in Example 3 is the same as in Example 1, except for the layer 110 being replaced with a layer 113 similar to that described in Example 2, and the layer 114 being replaced with a layer 111 similar to that described in Example 3.

Advantages and Improvements

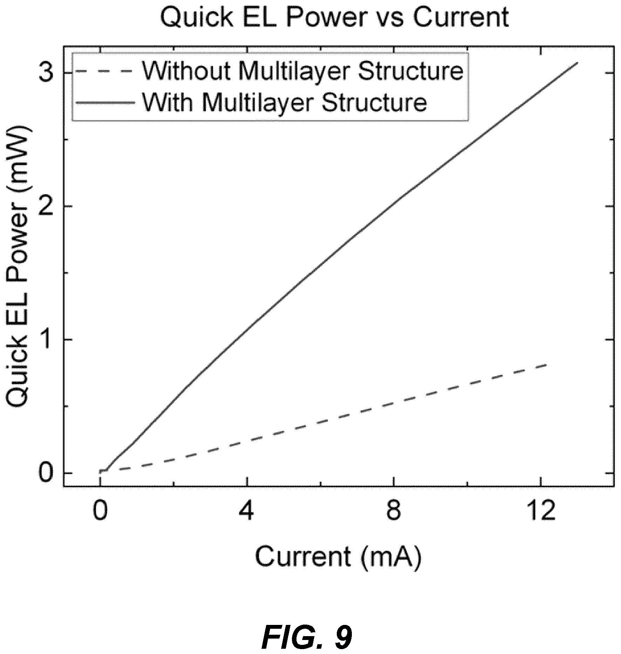

FIG. 9 shows the output power measured for LEDs with an n-side multilayer structure 101 and without an n-side multilayer structure 101 (a conventional UV-C LED). The output power of the LEDs was evaluated by measuring the light output using a silicon photodetector through the back of the substrate. This is commonly referred to as an "on-wafer" measurement, or "quick electroluminescence (EL)." It is clear from FIG. 9 that the use of an optimized multilayer structure leads to a significant increase in the output power of about 300% compared to conventional UV-C LED devices.

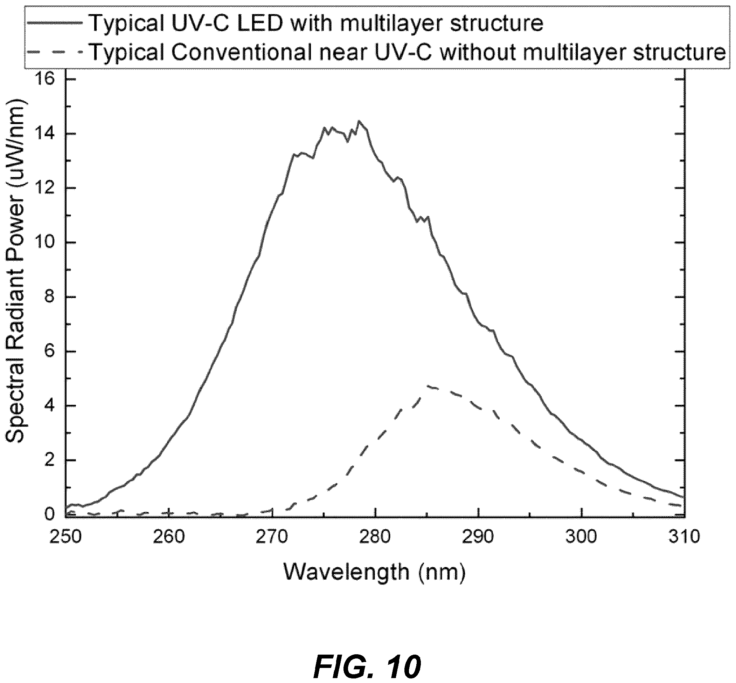

FIG. 10 shows a comparison of typical spectral radiant power between a typical UV-C LED with an n-side multilayer structure 101 and a near UV-C LED without an n-side multilayer structure 101 (a conventional UV LED). The peak spectral radiant power and integrated spectral radiant power for the novel UV-C LED both demonstrate an above 300% increase compared with the conventional near UV-C LED.

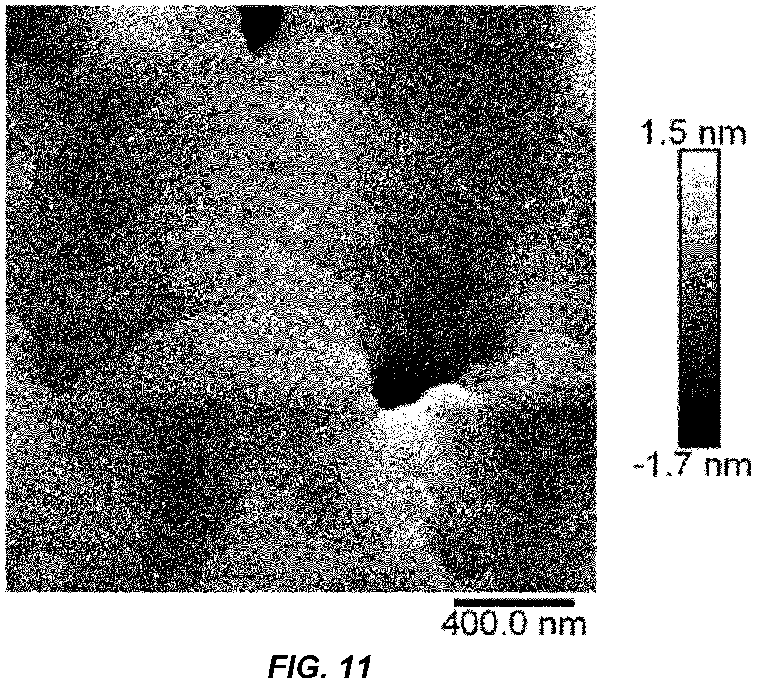

FIG. 11 shows the typical surface morphology of an active region of a conventional UV-C or near UV-C LED. As can be seen, the surface is extremely smooth overall and does not contain any disc-hillocks, in contrast to FIGS. 5A and 5B. It can be noted that the average RMS roughness of the conventional UV LED active region surface over a 2 $\mu$m $\times$ 2 $\mu$m region is lower than that of the UV LED with the novel multilayer structure.

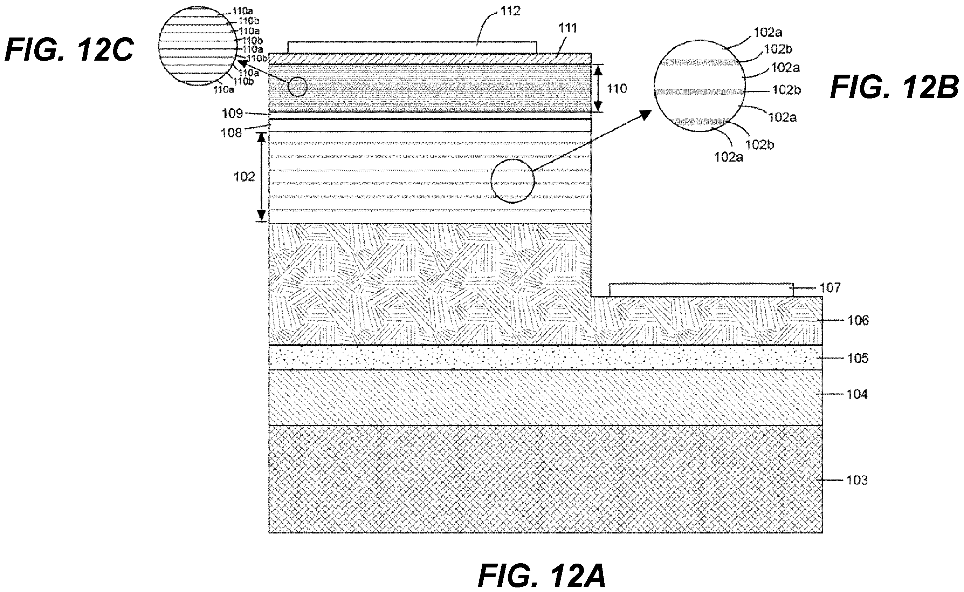

FIG. 12A shows the typical schematic sectional view of a conventional UV-C LED (wherein FIGS. 12B and 12C are magnified callouts of layers 102a and 102b, and 110a and 110b, respectively). Compared with FIG. 3A, it is evident that the n-side multilayer structure 101 is not present.

Alternatives and Modifications

A number of alternatives and modifications are available for the present invention, as set forth below:

1. A III-nitride light emitting device, comprising: a III-nitride-based n-side multilayer structure having regions of higher Al composition compared to adjacent layers.

2. A III-nitride light emitting device, comprising: at least one III-nitride semiconductor layer has a (102) rocking curve full width at half-maximum of between 150-500 arcseconds or dislocation density between $1 \times 10^7$ to $1 \times 10^{10}$ cm$^{-2}$.

3. The device of 2, wherein the III-nitride semiconductor layer is AlN.

4. The device of 1, wherein at least one III-nitride semiconductor layer of the n-side multilayer structure has a (102) rocking curve full width at half-maximum of between 150-500 arcseconds or dislocation density between $1 \times 10^7$ to $1 \times 10^{10}$ cm$^{-2}$.

5. A III-nitride light emitting device, comprising: an active region that is undulating.

6. The device of 1-4, wherein an active region is undulating.

7. The device of 1-6, wherein the n-side multilayer structure does not emit light.

8. The device of 1-7, wherein the active region is on, above, below, or adjacent to the n-side multilayer structure.

9. The device of 1-8, wherein at least some of the n-side multilayer structure emits light and is part of the undulating active region.

10. The device of 1-9, wherein at least one of the individual layers of the n-side multilayer structure contains at least some Si, Ge, Mg, C, O, Be, Ca, Fe, or other impurity.

11. The device of 1-10, wherein at least one of the individual layers of the active region contains at least some Si, Ge, Mg, C, O, Be, Ca, Fe, or other impurity.

12. The device of 1-11, wherein the active region contains a lower concentration of Si, Ge, Mg, C, O, Be, Ca, Fe, or other impurity compared to the n-side multilayer structure.

13. The device of 1-12, wherein the active region contains an equal or higher concentration of Si, Ge, Mg, C, O, Be, Ca, Fe, or other impurity compared to the multilayer structure.

14. The device of 1-13, wherein the device is formed on or above a free-standing GaN, AlN, sapphire (including flat sapphire, patterned sapphire, or any other type of sapphire), SiC, or other growth substrate.

15. The device of 1-14, wherein the basal plane of the growth substrate used is the c-plane.

16. The device of 1-15, wherein the miscut of the substrate is between 0.2 and 1 degree towards the m-direction.

17. The device of 1-15, wherein the miscut of the substrate is between 0.2 and 1 degree towards the a-direction.

18. The device of 1-15, wherein the miscut of the substrate is greater than or equal to 1 degree towards the m-direction.

19. The device of 1-15, wherein the miscut of the substrate is greater than or equal to 1 degree towards the a-direction.

20. The device of 1-15, wherein the miscut of the substrate is less than or equal to 0.2 degrees towards the m-direction.

21. The device of 1-15, wherein the miscut of the substrate is less than or equal to 0.2 degrees towards the a-direction.

22. The device of 1-21, wherein the impurity concentration of the mentioned impurities in the multilayer structure is in the range of $10^{15}$ to $10^{21}$ cm$^{-3}$.

23. The device of 1-21, wherein the impurity concentration of the mentioned impurities in the multilayer structure is in the range of $10^{16}$ to $10^{21}$ cm$^{-3}$.

24. The device of 1-21, wherein the impurity concentration of the mentioned impurities in the multilayer structure is in the range of $10^{16}$ to $10^{20}$ cm$^{-3}$.

25. The device of 1-21, wherein the impurity concentration of the mentioned impurities in the multilayer structure is in the range of $10^{17}$ to $10^{20}$ cm$^{-3}$.

26. The device of 1-21, wherein the impurity concentration of the mentioned impurities in the multilayer structure is in the range of $10^{18}$ to $10^{20}$ cm$^{-3}$.

27. The device of 1-21, wherein the impurity concentration of the mentioned impurities in the active region is in the range of $10^{15}$ to $10^{21}$ cm$^{-3}$.

28. The device of 1-21, wherein the impurity concentration of the mentioned impurities in the active region is in the range of $10^{16}$ to $10^{21}$ cm$^{-3}$.

29. The device of 1-21, wherein the impurity concentration of the mentioned impurities in the active region is in the range of $10^{16}$ to $10^{20}$ cm$^{-3}$.

30. The device of 1-21, wherein the impurity concentration of the mentioned impurities in the active region is in the range of $10^{17}$ to $10^{20}$ cm$^{-3}$.

31. The device of 1-21, wherein the impurity concentration of the mentioned impurities in the active region is in the range of $10^{18}$ to $10^{20}$ cm$^{-3}$.

32. The device of 1-31, further comprising at least one III-nitride electron blocking layer on or above the active region, having a composition $Al_xGa_{1-x}N$ wherein $0 \leq x \leq 1$.

33. The device of 1-32, wherein the electron blocking layer contains at least some Mg, Be, Ca, C, O, Fe, or other impurity.

34. The device of 1-33, wherein the impurity concentration of the mentioned impurities in the electron blocking layer is in the range of $10^{15}$ to $10^{21}$ cm$^{-3}$.

35. The device of 1-33, wherein the impurity concentration of the mentioned impurities in the electron blocking layer is in the range of $10^{16}$ to $10^{21}$ cm$^{-3}$.

36. The device of 1-33, wherein the impurity concentration of the mentioned impurities in the electron blocking layer is in the range of $10^{16}$ to $10^{20}$ cm$^{-3}$.

37. The device of 1-33, wherein the impurity concentration of the mentioned impurities in the electron blocking layer is in the range of $10^{17}$ to $10^{20}$ cm$^{-3}$.

38. The device of 1-33, wherein the impurity concentration of the mentioned impurities in the electron blocking layer is in the range of $10^{18}$ to $10^{20}$ cm$^{-3}$.

39. The device of 1-38, further comprising at least one III-nitride superlattice on or above the active region, having at least two periods of alternating layers of $Al_xGa_{1-x}N$ and $Al_yGa_{1-y}N$, where $0 \leq x \leq 1$ and $0 \leq y \leq 1$, and containing at least some Mg, Be, Ca, C, O, Fe, or other impurity.

40. The device of 1-39, wherein the individual layers of the III-nitride superlattice are between 0.3 nm and 3 nm thick.

41. The device of 1-39, wherein the impurity concentration of the mentioned impurities in the p-type superlattice layers are in the range of $10^{15}$ to $10^{21}$ cm$^{-3}$.

42. The device of 1-39, wherein the impurity concentration of the mentioned impurities in the p-type superlattice layers are in the range of $10^{16}$ to $10^{21}$ cm$^{-3}$.

43. The device of 1-39, wherein the impurity concentration of the mentioned impurities in the p-type superlattice layers are in the range of $10^{16}$ to $10^{20}$ cm$^{-3}$.

44. The device of 1-39, wherein the impurity concentration of the mentioned impurities in the p-type superlattice layers are in the range of $10^{17}$ to $10^{20}$ cm$^{-3}$.

45. The device of 1-39, wherein the impurity concentration of the mentioned impurities in the p-type superlattice layers are in the range of $10^{18}$ to $10^{20}$ cm$^{-3}$.

46. The device of 1-38, further comprising at least one III-nitride p-type layer on or above the active region that is 3D polarization doped.

47. The device of 46, wherein the 3D polarization doped p-type III-nitride layer has a continuously varying composition of between $Al_xGa_{1-x}N$ and $Al_yGa_{1-y}N$ where $0 \leq x \leq 1$ and $0 \leq y \leq 1$, and containing at least some Mg, Be, Ca, C, O, Fe, or other impurity at a continuously varying or constant composition.

48. The device of 46-47, wherein the impurity concentration of the mentioned impurities in the p-type AlGaN layer with a continuously varying or constant composition is in the range of $10^{15}$ to $10^{21}$ cm$^{-3}$.

49. The device of 46-47, wherein the impurity concentration of the mentioned impurities in the p-type AlGaN layer with a continuously varying or constant composition is in the range of $10^{16}$ to $10^{21}$ cm$^{-3}$.

50. The device of 46-47, wherein the impurity concentration of the mentioned impurities in the p-type AlGaN layer with a continuously varying or constant composition is in the range of $10^{16}$ to $10^{20}$ cm$^{-3}$.

51. The device of 46-47, wherein the impurity concentration of the mentioned impurities in the p-type AlGaN layer with a continuously varying or constant composition is in the range of $10^{17}$ to $10^{20}$ cm$^{-3}$.

52. The device of 46-47, wherein the impurity concentration of the mentioned impurities in the p-type AlGaN layer with a continuously varying or constant composition is in the range of $10^{18}$ to $10^{20}$ cm$^{-3}$.

53. The device of 46-47, wherein the Mg concentration in the p-type AlGaN layer with a continuously varying composition is below $10^{21}$ cm$^{-3}$.

54. The device of 46-47, wherein the Mg concentration in the p-type AlGaN layer with a continuously varying composition is below $10^{20}$ cm$^{-3}$.

55. The device of 46-47, wherein the Mg concentration in the p-type AlGaN layer with a continuously varying composition is below $10^{19}$ cm$^{-3}$.

56. The device of 46-47, wherein the Mg concentration in the p-type AlGaN layer with a continuously varying composition is below $10^{18}$ cm$^{-3}$.

57. The device of 46-47, wherein the Mg concentration in the p-type AlGaN layer with a continuously varying composition is below $10^{17}$ cm$^{-3}$.

58. The device of 46-47, wherein the Mg concentration in the p-type AlGaN layer with a continuously varying composition is below $10^{16}$ cm$^{-3}$.

59. The device of 46-47, wherein the Mg concentration in the p-type AlGaN layer with a continuously varying composition is below $10^{15}$ cm$^{-3}$.

60. The device of 1-38, further comprising at least one III-nitride p-type layer on or above the active region, having a composition of $Al_xGa_{1-x}N$ where $0 \leq x \leq 1$, and containing at least some Mg, Be, Ca, C, O, Fe, or other impurity..

61. The device of 60, wherein the impurity concentration of the mentioned impurities in the p-type AlGaN layer with a continuously varying or constant composition is in the range of $10^{15}$ to $10^{21}$ cm$^{-3}$.

62. The device of 60, wherein the impurity concentration of the mentioned impurities in the p-type AlGaN layer with a continuously varying or constant composition is in the range of $10^{16}$ to $10^{21}$ cm$^{-3}$.

63. The device of 60, wherein the impurity concentration of the mentioned impurities in the p-type AlGaN layer with a continuously varying or constant composition is in the range of $10^{16}$ to $10^{20}$ cm$^{-3}$.

64. The device of 60, wherein the impurity concentration of the mentioned impurities in the p-type AlGaN layer with a continuously varying or constant composition is in the range of $10^{17}$ to $10^{20}$ cm$^{-3}$.

65. The device of 60, wherein the impurity concentration of the mentioned impurities in the p-type AlGaN layer with a continuously varying or constant composition is in the range of $10^{18}$ to $10^{20}$ cm$^{-3}$.

66. The device of 1-65, further comprising a conducting layer on or above the rest of the device.

67. The device of 66, wherein the conducting layer comprises at least some IZO or ITO.

68. The device of 66, wherein the conducting layer comprises at least one metallic layer composed of V, Al, Ni, Au, Ag, Pt, Pd, In, and/or other metal.

69. The device of 66, wherein the conducting layer forms a tunnel junction to a p-type layer below it.

70. The device of 69, wherein the conducting layer is partially or fully transparent.

71. The device of 70, wherein the conducting layer is composed of $Ga_2O_3$.

72. The device of 70, wherein the conducting layer is n-type $Al_xGa_{1-x}N$ where $0 \leq x \leq 1$ and contains at least some Si, Ge, or other impurity.

73. The device of 70, wherein the impurity concentration of the mentioned impurities in the transparent conducting $Al_xGa_{1-x}N$ layer is in the range of $10^{15}$ to $10^{21}$ cm$^{-3}$.

74. The device of 70, wherein the impurity concentration of the mentioned impurities in the transparent conducting $Al_xGa_{1-x}N$ layer is in the range of $10^{16}$ to $10^{21}$ cm$^{-3}$.

75. The device of 70, wherein the impurity concentration of the mentioned impurities in the transparent conducting $Al_xGa_{1-x}N$ layer is in the range of $10^{16}$ to $10^{20}$ cm$^{-3}$.

76. The device of 70, wherein the impurity concentration of the mentioned impurities in the transparent conducting $Al_xGa_{1-x}N$ layer is in the range of $10^{17}$ to $10^{20}$ cm$^{-3}$.

77. The device of 70, wherein the impurity concentration of the mentioned impurities in the transparent conducting $Al_xGa_{1-x}N$ layer is in the range of $10^{18}$ to $10^{20}$ cm$^{-3}$.

78. The device of 66-77, wherein the conducting layers are directly on or above a p-type Mg-doped $Al_xGa_{1-x}N$ / Mg-doped $Al_yGa_{1-y}N$ (x>y) superlattice.

79. The device of 78, wherein the conducting layer comprises n-type $Al_xGa_{1-x}N$ that is grown directly on or above the p-type Mg-doped $Al_xGa_{1-x}N$ / Mg-doped $Al_yGa_{1-y}N$ (x>y) superlattice.

80. The device of 76, wherein the growth temperature of the n-type $Al_xGa_{1-x}N$ conducting layer is lower than that of the p-type Mg-doped $Al_xGa_{1-x}N$ / Mg-doped $Al_yGa_{1-y}N$ (x>y) superlattice.

81. The device of 76, wherein the n-type $Al_xGa_{1-x}N$ conducting layer is grown on or above the Mg-doped $Al_yGa_{1-y}N$ of the p-type Mg-doped $Al_xGa_{1-x}N$ / Mg-doped $Al_yGa_{1-y}N$ (x>y) superlattice.

82. The device of 76, wherein the n-type $Al_xGa_{1-x}N$ conducting layer is grown on or above the Mg-doped $Al_xGa_{1-x}N$ of the p-type Mg-doped $Al_xGa_{1-x}N$ / Mg-doped $Al_yGa_{1-y}N$ (x>y) superlattice.

83. The device of 75-79, wherein the thickness of each layer in the p-type Mg-doped $Al_xGa_{1-x}N$ / Mg-doped $Al_yGa_{1-y}N$ (x>y) superlattice is less than 5 nm.

84. The device of 75-79, wherein the thickness of each layer in the p-type Mg-doped $Al_xGa_{1-x}N$ / Mg-doped $Al_yGa_{1-y}N$ (x>y) superlattice is less than 3 nm.

85. The device of 75-79, wherein the thickness of each layer in the p-type Mg-doped $Al_xGa_{1-x}N$ / Mg-doped $Al_yGa_{1-y}N$ (x>y) superlattice is less than 2 nm.

86. The device of 75-82, wherein the as grown Mg-doped $Al_xGa_{1-x}N$ / Mg-doped $Al_yGa_{1-y}N$ (x>y) superlattice has p-type conductance without any additional treatments after material growth.

87. The device of 63-74, wherein the conducting layers are directly on or above a 3D polarization p-type doped layer composed of AlGaN with a continuously varying composition of between $Al_xGa_{1-x}N$ and $Al_yGa_{1-y}N$ wherein $0 \leq x \leq 1$ and $0 \leq y \leq 1$, as described in 43-56.

88. The device of 87, wherein the conducting layer comprises n-type $Al_xGa_{1-x}N$ ($0 \leq x \leq 1$) that is grown directly on or above the 3D polarization doped p-type AlGaN layer.

89. The device of 88, wherein the growth temperature of the n-type $Al_xGa_{1-x}N$ conducting layer is lower than that of the 3D polarization doped p-type AlGaN layer.

90. The device of 87-89, wherein the as grown 3D polarization doped p-type AlGaN layer has p-type conductance without any additional treatments after material growth.

91. The device of 66, wherein the conducting layer includes a homogeneous p-type GaN layer on or above the rest of the device, containing at least some Mg, Be, Ca, C, O, Fe, or other impurity.

92. The device of 66, wherein the conducting layer includes a p-type GaN layer covering less than 70% of the surface on or above the rest of the device, containing at least some Mg, Be, Ca, C, O, Fe, or other impurity.

93. The device of 91-92, wherein the impurity concentration of the mentioned impurities in the p-GaN layer is in the range of $10^{15}$ to $10^{21}$ cm$^{-3}$.

94. The device of 91-92, wherein the impurity concentration of the mentioned impurities in the p-GaN layer is in the range of $10^{16}$ to $10^{21}$ cm$^{-3}$.

95. The device of 91-92, wherein the impurity concentration of the mentioned impurities in the p-GaN layer is in the range of $10^{16}$ to $10^{20}$ cm$^{-3}$.

96. The device of 91-92, wherein the impurity concentration of the mentioned impurities in the p-GaN layer is in the range of $10^{17}$ to $10^{20}$ cm$^{-3}$.

97. The device of 91-92, wherein the impurity concentration of the mentioned impurities in the p-GaN layer is in the range of $10^{18}$ to $10^{20}$ cm$^{-3}$.

98. The device of 91-92, wherein the conducting layer further comprises at least one metallic or conductive oxide layer on or above the p-type GaN layer.

99. The device of 98, wherein the layer comprises V, Al, Ni, Au, Ag, Pt, Pd, In, and/or other metals on or above the p-type GaN layer.

100. The device of 98, wherein the conducting layer comprises at least one layer of IZO, ITO, $Ga_2O_3$, or other conductive oxide on or above the p-type GaN layer.

101. The device of 1-100, wherein the entire device is grown on or above a layer of AlN of dislocation density more than $10^7$ cm$^{-2}$.

102. The device of 1-100, wherein the entire device is grown on or above a layer of AlN of dislocation density more than $10^8$ cm$^{-2}$.

103. The device of 1-100, wherein the entire device is grown on or above a layer of AlN of dislocation density more than $5 \times 10^8$ cm$^{-2}$.

104. The device of 1-103, wherein the active region is undulating with an amplitude of at least 0.5 nm over a 2 $\mu$m by 2 $\mu$m region.

105. The device of 1-103, wherein the active region is undulating with an amplitude of at least 1 nm over a 2 $\mu$m by 2 $\mu$m region.

106. The device of 1-103, wherein the active region is undulating with an amplitude of at least 2 nm over a 2 $\mu$m by 2 $\mu$m region.

107. The device of 1-103, wherein the active region is undulating with an amplitude of at least 5 nm over a 2 $\mu$m by 2 $\mu$m region.

108. The device of 1-107, wherein the active region surface has a disc-hillock morphology with an RMS roughness of between 0.5 to 15 nm over a 2 $\mu$m by 2 $\mu$m region, but comprises local regions at least 200 nm by 200 nm in size with an RMS roughness of less than 1 nm.

109. The device of 1-107, wherein the active region surface has a disc-hillock morphology with an RMS roughness of between 0.5 to 10 nm over a 2 $\mu$m by 2 $\mu$m region, but comprises local regions at least 200 nm by 200 nm in size with an RMS roughness of less than 1 nm.

110. The device of 1-107, wherein the active region surface has a disc-hillock morphology with an RMS roughness of between 0.5 to 10 nm over a 2 $\mu$m by 2 $\mu$m region, but comprises local regions at least 100 nm by 100 nm in size with an RMS roughness of less than 1 nm.

111. The device of 1-107, wherein the active region surface has a disc-hillock morphology with an RMS roughness of between 1 to 7 nm over a 2 μm by 2 μm region, but comprises local regions at least 100 nm by 100 nm in size with an RMS roughness of less than 0.8 nm.

112. The device of 108, wherein the active region surface comprises at least some islands 50-1000 nm in diameter, 1-50 nm tall.

113. The device of 108, wherein the active region surface comprises at least some islands 100-700 nm in diameter, 1-20 nm tall.

114. The device of 1-113, wherein a layer of reflective material is on, above, below, or around the device.

115. The device of 114, wherein that reflective material is $MgF_2$ or $SiO_2$.

116. The device of 114, wherein that reflective material is V, Al, Ni, Au, Ag, Pt, Pd, In, or any other metal.

117. A method for the fabrication of the device of 1-116, wherein a III-nitride material is deposited on or above a substrate.

118. The method of 117, wherein TMI is used in the growth of the device material layers.

119. The method of 117-118, wherein a higher flow of TMI is used in the growth of the device material layers compared to the flow of TMA and TMG.

120. The method of 117-119, wherein the flow of at least one of the metalorganic precursors is paused for at least 3 seconds in between the growth of the alternating layers in the multilayer structure.

121. The method of 117-120, wherein the flow of ammonia is paused for at least 3 seconds in between the growth of the alternating layers in the multilayer structure.

122. The method of 117-121, wherein the flow of at least one of the metalorganic precursors is paused for at least 3 seconds in between the growth of the different layers in the active region.

123. The method of 117-122, wherein the flow of ammonia is paused for at least 3 seconds in between the growth of the different layers in the active region.

124. The method of 117-123, wherein the flow of metalorganic precursor is paused for at least 3 seconds in order to create a layer of higher aluminum composition at least once in the device.

125. The method of 117-124, wherein the flow of ammonia is paused in order to create a layer of higher aluminum composition at least once in the device.

126. The method of 117-125, wherein the V to III ratio used in the growth of the multilayer structure is less than 500.

127. The method of 117-126, wherein the V to III ratio used in the growth of the multilayer structure is less than 100.

128. The method of 117-126, wherein the V to III ratio used in the growth of the multilayer structure is less than 50.

129. The method of 117-126, wherein the V to III ratio used in the growth of the multilayer structure is less than 20.

130. The method of 117-129, wherein the V to III ratio used in the growth of the AlGaN cladding layers in between the substrate and the interlayer is less than 500.

131. The method of 117-129, wherein the V to III ratio used in the growth of the AlGaN cladding layers in between the substrate and the interlayer is less than 100.

132. The method of 117-129, wherein the V to III ratio used in the growth of the AlGaN cladding layers in between the substrate and the interlayer is less than 50.

133. The method of 117-129, wherein the V to III ratio used in the growth of the AlGaN cladding layers in between the substrate and the interlayer is less than 20.

134. The method of 117-133, wherein the V to III ratio used in the growth of the layers in the active region is less than 500.

135. The method of 117-133, wherein the V to III ratio used in the growth of the layers in the active region is less than 100.

136. The method of 117-133, wherein the V to III ratio used in the growth of the layers in the active region is less than 50.

137. The method of 117-133, wherein the V to III ratio used in the growth of the layers in the active region is less than 20.

138. The method of 117-137, wherein the device is grown such that the principal surface of the device material is represented by a c-face, r-face, n-face, v-face, m-face, or a-face.

139. The method of 117-138, wherein the device is grown on a patterned substrate.

140. The method of 117-139, wherein the patterned substrate is a patterned sapphire substrate.

141. The method of 117-140, wherein all steps of the wafer fabrication occur at a temperature below 1000 C.

142. The method of 117-140, wherein all steps of the wafer fabrication occur at a temperature below 900 C.

143. The method of 117-140, wherein all steps of the wafer fabrication occur at a temperature below 800 C.

144. The method of 117-140, wherein all steps of the wafer fabrication occur at a temperature below 750 C.

145. The method of 117-140, wherein all steps of the wafer fabrication occur at a temperature below 700 C.

146. The method of 117-140, wherein all steps of the wafer fabrication occur at a temperature below 650 C.

147. The method of 117-140, wherein all steps of the wafer fabrication occur at a temperature below 600 C.

Conclusion

This concludes the description of the preferred embodiment of the present invention. The foregoing description of one or more embodiments of the invention has been presented for the purposes of illustration and description. It is not intended to be exhaustive or to limit the invention to the precise form disclosed. Many modifications and variations are possible in light of the above teaching. It is intended that the scope of the invention be limited not by this detailed description, but rather by the claims appended hereto.

**Claims**

1. A device, comprising:

   a light-emitting diode (LED) comprised of one or more III-nitride semiconductor layers containing aluminum, including an active region having a single or multiple quantum well structure emitting at an ultra-violet (UV) wavelength, and at least one cladding layer; and
   an n-side multilayer structure located adjacent to the active region of the LED, wherein the n-side multilayer structure contains one or more of the III-nitride semiconductor layers with a higher aluminum composition as compared to adjacent layers of the n-side multilayer structure, the active region and/or the cladding layer.

2. The device of claim 1, wherein the III-nitride semiconductor layers containing aluminum comprise $Al_xGa_{1-x}N$ alloys where $0 \leq x \leq 1$.

3. The device of claim 1 or claim 2, wherein the n-side multilayer structure provides an ability to fine-tune and control surface morphology and crystal quality, to achieve a specific targeted surface morphology and crystal quality in the active region.

4. The device of claim 3, wherein the n-side multilayer structure achieves an undulating active region.

5. The device of any of claims 1-4, wherein the active region's surface has a disc-hillock morphology with a root mean square (RMS) roughness of between 0.5 to 15 nm over a 2 $\mu$m by 2 $\mu$m region, but comprises local regions at least 100 nm by 100 nm in size with an RMS roughness of less than 1 nm.

6. The device of any of claims 1-5, wherein at least one of the III-nitride semiconductor layers has a (102) rocking curve full width at half-maximum of between 150-500 arcseconds or dislocation density between $1 \times 10^7$ to $1 \times 10^{10}$ cm$^{-2}$.

7. The device of any of claims 1-6, wherein the n-side multilayer structure comprises one or more of the III-nitride semiconductor layers with different aluminum molar fractions, such as $Al_xGa_{1-x}N$ where $0 \leq x \leq 1$, $Al_yGa_{1-y}N$ where $0 \leq y \leq 1$, and $Al_zGa_{1-z}N$ where $0 \leq z \leq 1$.

8. The device of claim 7, wherein the one or more of the III-nitride semiconductor layers are formed in a repeating pattern, one or more of the III-nitride semiconductor layers differ in thickness, at least one of the III-nitride semiconductor layers has a thickness of less than 200 angstroms, and the n-side multilayer structure has a total thickness of less than 500 nm.

9. The device of any of the preceding claims, wherein the n-side multilayer structure is in contact with the active region.

10. The device of any of the preceding claims, wherein the III-nitride semiconductor layers of the n-side multilayer structure are undoped, unintentionally doped, doped, and/or modulation doped, with a doping concentration adjusted to be $5 \times 10^{21}$/cm$^3$ or less and n-type when the III-nitride semiconductor layers are doped or modulation doped.

11. The device of any of the preceding claims, further comprising:

    a p-cladding layer that is a short period superlattice (SPSL) made of alternating layers of $Al_kGa_{1-k}N$ and $Al_mGa_{1-m}N$ doped with magnesium, where $0 \leq k \leq 1$ and $0 \leq m \leq 1$;
    a three-dimensional (3D) polarization doped III-nitride semiconductor layer grown on or above a p-type III-nitride semiconductor layer of the LED;
    a tunnel junction grown on or above a p-type III-nitride semiconductor layer of the LED, wherein the tunnel junction comprises an n-type III-nitride semiconductor layer; and/or
    a p-type doped $Al_xGa_{1-x}N$ hole injection layer grown on or above a III-nitride semiconductor layer of the LED.

12. A method, comprising:

    fabricating a III-nitride multilayer structure on or above a substrate; and
    fabricating a light-emitting diode (LED) comprised of one or more III-nitride semiconductor layers containing aluminum, including an active region having a single or multiple quantum well structure emitting at an ultra-violet (UV) wavelength, and at least one cladding layer; and

wherein the III-nitride multilayer structure is located adjacent to the active region of the LED, and the III-nitride multilayer structure contains III-nitride semiconductor layers with a higher aluminum composition as compared to adjacent layers of the III-nitride multilayer structure, the active region and/or the cladding layer.

13. The method of claim 12, wherein the III-nitride semiconductor layers containing aluminum comprise $Al_xGa_{1-x}N$ alloys where $0 \le x \le 1$

14. The method of claim 12 or 13, wherein:

trimethylindium is used in the growth of the III-nitride semiconductor layers,
a higher flow of the trimethylindium is used in the growth of the III-nitride semiconductor layers as compared to a flow of trimethylaluminum and trimethylgallium,
a flow of at least one metalorganic precursor and/or ammonia is paused for at least 3 seconds in between growth of alternating layers in the III-nitride multilayer structure,
a flow of at least one metalorganic precursor and/or ammonia is paused for at least 3 seconds in between growth of different layers in the active region,
a flow of at least one metalorganic precursor and/or ammonia is paused for at least 3 seconds in order to create a layer of higher aluminum composition at least once in the LED, or
a V to III ratio used in growth of the III-nitride multilayer structure is less than 500, preferably less than 100, more preferably less than 50, and most preferably less than 20.

15. The method of claim 12, 13 or 14, wherein:

the cladding layer is an AlGaN cladding layer and a V to III ratio used in growth of the AlGaN cladding layer in between the substrate and an interlayer is less than 500, preferably less than 100, more preferably less than 50, and most preferably less than 20, or
a V to III ratio used in growth of layers in the active region is less than 500, preferably less than 100, more preferably less than 50, and most preferably less than 20.

*FIG. 1D*

*FIG. 1C*

*FIG. 1B*

*FIG. 1A*

EP 4 276 921 A1

*FIG. 2C*

*FIG. 2B*

*FIG. 2A*

FIG. 3A

FIG. 3B

FIG. 3C

FIG. 3D

**FIG. 4A**

**FIG. 4C**

**FIG. 4B**

EP 4 276 921 A1

**FIG. 5A**

**FIG. 5B**

9.3 µm

-7.7 µm

2 µm

2 µm

*FIG. 6*

**FIG. 7**

EP 4 276 921 A1

*FIG. 8*

Load substrate into reactor 800 → Grow buffer layer 801 → Grow n-contact/cladding layer 802 → Grow multilayer structure 803 → Grow active region 804 → Grow spacer layer 805 → Grow EBL 806 → Grow p-contact/cladding layer 807 → Grow tunnel junction 808 → Etch to expose n-contact 809 → End result 810

FIG. 9

EP 4 276 921 A1

*FIG. 10*

Legend:
— Typical UV-C LED with multilayer structure
- - - Typical Conventional near UV-C without multilayer structure

X-axis: Wavelength (nm)
Y-axis: Spectral Radiant Power (uW/nm)

FIG. 11

FIG. 12C

FIG. 12B

FIG. 12A

EP 4 276 921 A1

Europäisches
Patentamt

European
Patent Office

Office européen
des brevets

# EUROPEAN SEARCH REPORT

**Application Number**

**EP 23 17 2642**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/303891 A1 (CHUA CHRISTOPHER L [US] ET AL) 15 December 2011 (2011-12-15) * paragraphs [0011], [0044]; figure 6 * | 1-11 | INV. H01L33/00 H01L33/30 |
| X | KR 2018 0084508 A (LG INNOTEK CO LTD [KR]) 25 July 2018 (2018-07-25) * paragraphs [0031] – [0047], [0058] – [0060]; figure 1 * | 1,12-15 | |

**TECHNICAL FIELDS SEARCHED (IPC)**

H01L

The present search report has been drawn up for all claims

| Place of search | Date of completion of the search | Examiner |
|---|---|---|
| The Hague | 29 September 2023 | Chin, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

..............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 2642

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2023

| Patent document cited in search report | Publication date | Patent family member(s) | Publication date |
|---|---|---|---|
| US 2011303891 A1 | 15-12-2011 | NONE | |
| KR 20180084508 A | 25-07-2018 | NONE | |

## REFERENCES CITED IN THE DESCRIPTION

### Patent documents cited in the description

- US 30999423, Michael Wang, Christian Zollner, Yifan Yao, Michael Iza, and Shuji Nakamura

- US 63341024, Michael Wang, Christian Zollner, Yifan Yao, Michael Iza, and Shuji Nakamura